# EUROPEAN PATENT SPECIFICATION

(11) **EP 2 824 549 B1**
(45) Date of publication and mention of the grant of the patent: **07.08.2019**
(21) Application number: 13758637.6
(22) Date of filing: 25.01.2013
(51) Int. Cl.: G01L 1/14, G01R 27/26, G06F 3/044

(54) **SENSOR DEVICE, INPUT DEVICE, AND ELECTRONIC APPARATUS**
SENSORVORRICHTUNG, EINGABEVORRICHTUNG UND ELEKTRONISCHE VORRICHTUNG
DISPOSITIF DE CAPTEUR, DISPOSITIF D'ENTRÉE ET APPAREIL ÉLECTRONIQUE

(30) Priority: 09.03.2012 JP 2012052821; 27.06.2012 JP 2012144470
(43) Date of publication of application: 14.01.2015
(73) Proprietor: Sony Corporation, Tokyo 108-0075 (JP)
(72) Inventor: IIDA, Fumihiko, Tokyo 108-0075 (JP); KAWAGUCHI, Hiroto, Tokyo 108-0075 (JP); HASEGAWA, Hayato, Tokyo 108-0075 (JP); ITAYA, Takashi, Tokyo 108-0075 (JP); KANO, Toshio, Tokyo 108-0075 (JP)
(74) Representative: Müller Hoffmann & Partner
(86) International application number: PCT/JP2013/000380
(87) International publication number: WO 2013/132736

(56) References cited:
- EP-A2- 2 149 838
- JP-A- 2011 180 739
- US-A1- 2008 202 251
- US-A1- 2011 090 175
- US-A1- 2011 096 025
- US-A1- 2011 210 927

## Description

### Technical Field

The present technology relates to a sensor device including a capacitive element, and to an input device and an electronic apparatus.

### Background Art

An input device including a capacitive element is known as an input device for an electronic apparatus. For example, Patent Document 1 discloses an input device capable of detecting an operation by an operating element based on a change in capacitance of the capacitive element.

US 2011/0090175 A1 discloses a capacitive touch panel, including: a plurality of coordinate detection electrodes for detecting X-Y position coordinates; a first substrate including the plurality of coordinate detection electrodes; and a second substrate disposed to be opposed to the first substrate, in which: one of the first substrate and the second substrate includes an elastic layer lower in rigidity than the second substrate and a conductive layer having conductivity; the elastic layer and the conductive layer are disposed between the plurality of coordinate detection electrodes and the second substrate; a space between the first substrate and the second substrate defined by a plurality of nonconductive spacers; and an antireflective layer is formed on at least one of an interface between the space and the first substrate and an interface between the space and the second substrate.

EP 2 149 838 A2 discloses a display device having an electrostatic capacity touch panel that includes: X electrodes XP and Y electrodes YP which intersect each other via a first insulating layer; and a plurality of Z electrodes ZP disposed in a floating state via a second insulating layer. For the second insulating layer, a material such as an elastic insulating material which changes in thickness by pressing of touch is used. The Z electrode is disposed so as to overlap both one of the X electrodes and one of the Y electrodes. A pad part of the X electrode has a largest area in the vicinity of a thin line part of the X electrode, and a smallest area in the vicinity of the thin line part of the adjacent X electrode. An area of the pad part is reduced as the pad part departs from the thin line part of the X electrode.

US 2008/0202251 A1 discloses a capacitive pressure that comprises a laminated arrangement with a first flexible, electrically insulating carrier film carrying a first capacitor electrode, a second flexible, electrically insulating carrier film carrying a second capacitor electrode and a flexible, electrically insulating spacer film sandwiched between the first and second carrier films. The spacer film has a through-hole or recess therein, with respect to which the first and second capacitor electrodes are arranged opposite one another, in such a way that the first and second electrodes are brought closer together by resilient bending of the first and/or second carrier film into the through-hole or recess under the action of a compressive force acting on the pressure sensor.

US 2011/0096025 A1 discloses methods, systems, and apparatus related to touch sensors that are configured to measure input applied to the sensor from a user. Some implementations involve the measurement of changes in capacitance between pairs of adjacent patterned electrodes to detect input at a touch sensor.

US 2011/0210927 A1 discloses a display device that includes a drive control section operatively coupled to a signal line and a display section. The signal line has a first voltage. In one example, the display section includes: a touch detection element which outputs a touch voltage; and an electrode which has a second voltage. In one example, the drive control section increases a potential difference between the first voltage and the second voltage before the touch detection element outputs the touch voltage.

Patent Document 1: Japanese Patent Application Laid-open No. 2011-170659

### Summary of Invention

### Problem to be solved by the Invention

The input device described in Patent Document 1 detects a pressing force associated with the operation by the operating element. So, if an input device can detect a smaller pressing force than that of a publicly-known input device such as the input device described in Patent Document 1, the input device can be widely used in new applications.

In view of the circumstances as described above, it is an object of the present technology to provide a sensor device, an input device, and an electronic apparatus that are capable of detecting a small pressing force.

### Means for solving the Problem

This object is achieved by the subject-matter of the independent claim.

According to the claimed configuration, a sensor device can detect a small pressing force by using a capacitive element.

A support layer may include a second structure that is arranged in a space portion and has a second height shorter than a first height.

With this configuration, the sensor device can detect a smaller pressing force by the capacitive element by the action of the second structure.

The second structure may be formed on at least one of a first surface and a second surface.

With this configuration, the sensor device can detect a smaller pressing force by the capacitive element by the action of the second structure.

The sensor device may further include a third surface that is arranged on an opposite side of the first surface with respect to the second surface and is opposed to the second surface, and a reference electrode formed on the first surface. In this case, a first electrode is formed on the second surface, and a second electrode is formed on the third surface that is opposed to the second surface on the opposite side of the first surface.

With this configuration, the sensor device can detect a small pressing force in a mutual capacitance system.

In the sensor device, the first electrode may be formed on the first surface, and the second electrode may be formed on the second surface.

With this configuration, the sensor device can detect a small pressing force in a self-capacitance system.

In the sensor device, the first electrode and the second electrode may be formed on the first surface.

With this configuration, the sensor device can detect a small pressing force in a self-capacitance system.

The sensor device may further include a reference electrode formed on the first surface, and the first electrode and the second electrode may be formed on the second surface.

With this configuration, the sensor device can detect a small pressing force in a mutual capacitance system.

In the sensor device, a first structure may be formed of a plurality of columnar bodies, and the plurality of columnar bodies may be regularly arrayed.

With this configuration, in the sensor device, the support layer can impart a uniform elastic force to the first surface.

Each of the plurality of columnar bodies may be formed to have one of a circular cross section and a polygonal cross section that are parallel to the first surface.

With this configuration, in the sensor device, the support layer can impart a uniform elastic force to the first surface.

### Effect of the Invention

According to the present technology, it is possible to provide a sensor device, an input device, and an electronic apparatus that are capable of detecting a small pressing force.

### Brief Description of Drawings

Fig. 1 is a plan view of an input device.
Fig. 2 is a cross-sectional view of the input device taken along the line A-A' of Fig. 1.
Fig. 3 is a block diagram of an electronic apparatus using the input device of Fig.1.
Fig. 4 is a plan view showing the configuration of electrodes of the input device shown in Fig. 1.
Fig. 5 is a diagram showing an example of output signals of the input device shown in Fig. 1.
Fig. 6 is an explanatory diagram of a first simulation.
Fig. 7 is an explanatory diagram of a second simulation.
Fig. 8 is an explanatory diagram of the second simulation.
Fig. 9 is a diagram showing a modified example of a first structure shown in Fig. 1.
Fig. 10 is a diagram showing a modified example of the first structure shown in Fig. 1.
Fig. 11 is a diagram showing a modified example of the first structure shown in Fig. 1.
Fig. 12 is an explanatory diagram of a third simulation.
Fig. 13 is an explanatory diagram of a fourth simulation.
Fig. 14 is a diagram showing an example of a method of forming the first structure and a second structure shown in Fig. 1.
Fig. 15 is a diagram showing modified examples of a support layer shown in Fig. 1.
Fig. 16 is a cross-sectional view of another input device.
Fig. 17 is a cross-sectional view of another input device.
Fig. 18 is a cross-sectional view of another input device.
Fig. 19 is a block diagram showing the configuration of another input device.
Fig. 20 is a fragmentary cross-sectional view of a main part of the input device.
Fig. 21 is a schematic diagram for describing characteristic examples of a sensor matrix in which a plurality of sensors are two-dimensionally arrayed.
Fig. 22 is a fragmentary plan view schematically showing the configuration example of electrodes of the sensor matrix.
Fig. 23 is a schematic diagram showing some configuration examples of electrodes.
Fig. 24 is a fragmentary plan view schematically showing another configuration example of electrodes of the sensor matrix.
Fig. 25 is a partially enlarged view of the configuration example of electrodes.
Fig. 26 is a fragmentary plan view schematically showing still another configuration example of electrodes of the sensor matrix.
Fig. 27 is a cross-sectional view of another input device.
Fig. 28 is a cross-sectional view of an input device according to a modified example of Fig. 27.
Fig. 29 is a cross-sectional view of an input device according to a modified example of Fig. 27.
Fig. 30 is a cross-sectional view of an input device according to a modified example of Fig. 29.
Fig. 31 is a cross-sectional view of an input device according to a modified example of Fig. 29.
Fig. 32 is a cross-sectional view of an input device according to a modified example of Fig. 27.
Fig. 33 is an exploded perspective view of a main part of the input device of Fig. 32.
Fig. 34 is a cross-sectional view of an input device according to a modified example of Fig. 27.
Fig. 35 is a cross-sectional view of another input device.
Fig. 36 is a plan view of a flexible keyboard of the input device shown in Fig. 35.
Fig. 37 is a plan view of a support layer of the input device shown in Fig. 35.
Fig. 38 is a plan view of a base plate of the input device shown in Fig. 35.
Fig. 39 is a cross-sectional view of the input device taken along a direction of the line B-B' of Fig. 38.
Fig. 40 is a cross-sectional view of a main part, for describing an action of the input device shown in Fig. 35.
Fig. 41 is a cross-sectional view of a main part, for describing an action of the input device shown in Fig. 27. Mode(s) for Carrying Out the Invention

Hereinafter, the present technology will be described with reference to the drawings. The drawings show an X axis, a Y axis, and a Z axis that are orthogonal to one another. Those axes are common in the following description.

### <First Example>

### (Overall Configuration)

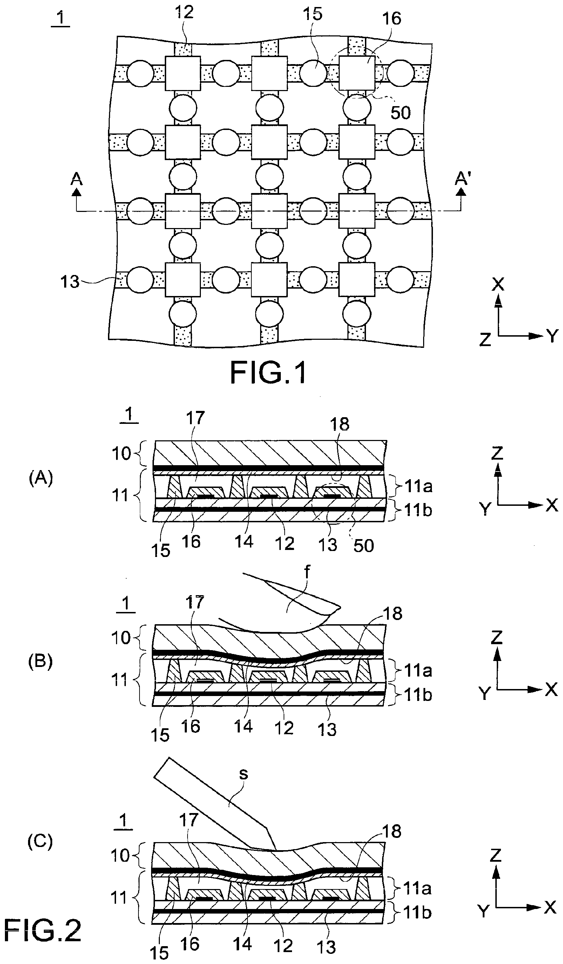

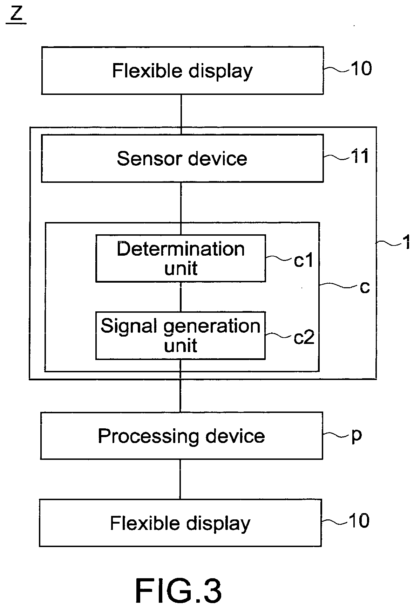

Fig. 1 is a plan view of an input device 1. Fig. 2 is a cross-sectional view of the input device 1 taken along the line A-A' of Fig. 1. Fig. 3 is a block diagram of an electronic apparatus z using the input device 1.

The input device 1 includes a flexible display 10 and a sensor device 11. In Fig. 1, the flexible display 10 is omitted and the internal structure of the sensor device 11 is schematically shown. Each of the input device 1 and the flexible display 10 has a plate-like shape extending in a direction perpendicular to the Z axis.

The flexible display 10 has a function as an input operation unit in the input device 1 and a function as a display unit in the electronic apparatus z. In other words, the flexible display 10 receives an operation by a user on an upper (front) surface in a Z-axis direction to serve as an input operation unit of the input device 1, and also displays an image corresponding to an operation by the user upwardly in the Z-axis direction to serve as a display unit of the electronic apparatus z. Examples of an operating element to perform an operation on the flexible display 10 include a finger f shown in Fig. 2(B) and a stylus s shown in Fig. 2(C).

As the flexible display 10, a commonly-available display can be used. Examples of such a commonly-available display include a so-called electronic paper, an organic EL (electroluminescence) panel, an inorganic EL panel, and a liquid crystal panel.

The sensor device 11 is arranged on a lower (back) surface in the Z-axis direction of the flexible display 10. Further, the sensor device 11 includes a base plate 11b including an X electrode 12 and a Y electrode 13. The X electrode 12 and the Y electrode 13 constitute a capacitive element of a mutual capacitance system. Furthermore, the sensor device 11 includes a reference electrode 14, and due to the proximity of the reference electrode 14 to the base plate 11b, a capacitance between the X electrode 12 and the Y electrode 13 changes. Typically, the reference electrode 14 is connected to a ground potential.

The input device 1 includes a controller c, and the controller c includes a determination unit c1 (detection unit) and a signal generation unit c2. The determination unit c1 detects an operation by the user based on a change in capacitance (between the X electrode 12 and the Y electrode 13) of the sensor device 11. The signal generation unit c2 generates an operation signal based on a detection result by the determination unit c1.

The electronic apparatus z shown in Fig. 3 includes a processing device p that performs processing based on the operation signal generated by the signal generation unit c2 of the input device 1. The operation signal processed by the processing device p is output to the flexible display 10 (input operation unit) as an image signal, for example.

### (Sensor Device)

The base plate 11b is constituted by a laminate of a plurality of base materials including a base material on which the X electrode 12 is formed and a base material on which the Y electrode 13 is formed. Here, since the input device 1 itself is deformable in a thickness direction, a deformable base plate is used as the base plate 11b. Examples of a material that forms the base materials include translucent or non-translucent resin materials made of PET (polyethylene terephthalate), PEN (polyethylene naphthalate), PI (polyimide), PC (polycarbonate), and the like.

It should be noted that in the case where the input device 1 itself is not deformable, the base plate 11b may not be deformable. In this case, as a material forming the base materials, for example, hard materials such as ceramic materials can be used.

Here, attention is focused on only the electrodes 12, 13, and 14. The X electrode 12, the Y electrode 13, and the reference electrode 14 are formed on respective three surfaces that are orthogonal to the Z axis and different from one another. Specifically, the X electrode 12 is formed on an upper surface of the base plate 11b in the Z-axis direction, the Y electrode 13 is formed in the base plate 11b, and the reference electrode 14 is formed on a lower surface of the flexible display 10 in the Z-axis direction. So, those electrode groups are aligned in the order of the reference electrode 14, the X electrode 12, and the Y electrode 13 from the top to the bottom in the Z-axis direction.

As described above, in the sensor device 11, the X electrode 12 and the Y electrode 13 constitute a capacitive element, and a change in capacitance between the X electrode 12 and the Y electrode 13 is detected. On the other hand, the X electrode 12 and the reference electrode 14 that are opposed to each other also constitute a capacitive element. When the reference electrode 14 comes close to the base plate 11b, a capacitance between the X electrode 12 and the reference electrode 14 increases, and a capacitance between the X electrode 12 and the Y electrode 13 decreases. In such a manner, in the sensor device 11, the proximity of the reference electrode 14 can be detected based on a decrease in capacitance between the X electrode 12 and the Y electrode 13.

It should be noted that here, the reference electrode 14 is formed on the lower surface of the flexible display 10 in the Z-axis direction. In the sensor device 11, however, the reference electrode 14 only needs to be arranged at a position upwardly opposed to the X electrode 12 in the Z-axis direction. So, the reference electrode 14 may be formed independently or may be formed in a base plate elastically deformable, which is different from the flexible display 10.

The sensor device 11 includes a plurality of first structures 15 arranged between the base plate 11b and the reference electrode 14. Each of the first structures 15 is a columnar body having a shape of a circular cone whose top is cut off by a surface parallel to a bottom surface, and having a center axis extending in the Z-axis direction. The plurality of first structures 15 are arranged regularly (at equal intervals) in an X-axis direction and a Y-axis direction. The first structures 15 are each formed of an elastically deformable material. Examples of such a material include PET, a silicon resin, and a sponge. The upper surface of the first structure 15 in the Z-axis direction and the lower surface of the reference electrode 14 in the Z-axis direction are bonded by a bonding layer 18. The bonding layer 18 is formed of a UV (ultraviolet) curable resin material, for example. It should be noted that the upper surface of the first structures 15 in the Z-axis direction and the lower surface of the reference electrode 14 in the Z-axis direction may be in direct contact with each other without the bonding layer 18.

Each of the first structures 15 has a function as a support member that supports the reference electrode 14 in a state where the reference electrode 14 is away from the base plate 11b. In other words, the first structures 15 form a space portion 17 between the base plate 11b and the reference electrode 14. With this, a support layer 11a containing the first structures 15 and the space portion 17 is formed between the base plate 11b and the reference electrode 14.

Second structures 16 are formed between the first structures 15 on the upper surface of the base plate 11b in the Z-axis direction. As shown in Fig. 1, each of the second structures 16 has a square cross section orthogonal to the Z axis and is arranged at each position at which the X electrode 12 and the Y electrode 13 cross each other. Further, as shown in Fig. 2, the height of the second structure 16 is lower than the height of the first structure 15 (or the support layer 11a). For that reason, the space portion 17 is formed between the second structures 16 and the reference electrode 14.

Fig. 2(B) shows a state where the flexible display 10 receives an operation by the finger f of a user. In this state, the finger f exerts a force on the flexible display 10 downwardly in the Z-axis direction. At that time, the flexible display 10 is deflected downwardly in the Z-axis direction. The reference electrode 14 bonded to the flexible display 10 is deflected downwardly in the Z-axis direction together with the flexible display 10 and comes close to the base plate 11b. With this, a capacitance of the sensor device 11 decreases.

As described above, the second structures 16 are formed between the reference electrode 14 and the base plate 11b. Since the material forming the second structures 16 has a specific dielectric constant higher than that of air present in the space portion 17, a capacitance between the X electrode 12 and the reference electrode 14 is large as compared with the structure without the second structures 16. As the capacitance between the X electrode 12 and the reference electrode 14 becomes larger, a change in capacitance between the X electrode 12 and the reference electrode 14, which is associated with a displacement of the reference electrode 14 to the X electrode 12 side, becomes larger.

On the other hand, as the change in capacitance between the X electrode 12 and the reference electrode 14 becomes larger, a change in capacitance between the X electrode 12 and the Y electrode 13 also becomes larger. So, in the sensor device 11, due to the action of the second structures 16, a change in capacitance between the X electrode 12 and the Y electrode 13, which is associated with a displacement of the reference electrode 14 to the X electrode 12 side, becomes larger. For that reason, in the sensor device 11, also in the case where the displacement of the reference electrode 14 to the X electrode 12 side is small, that displacement can be detected. In other words, the sensor device 11 has a high sensitivity for detecting a pressing force associated with an operation on the flexible display 10 by the user.

As shown in Fig. 2(B), in association with the downward deflection of the flexible display 10 by being pressed by the finger f, the first structures 15 below the flexible display 10 are elastically deformed. For that reason, when the finger f moves away from the flexible display 10, the flexible display 10 and the reference electrode 14 are pushed up by an elastic restoring force of the first structures 15, and the input device 1 is returned to the state shown in Fig. 2(A).

Fig. 2(C) shows a state where the flexible display 10 receives an operation by the stylus s. As in the case shown in Fig. 2(B) where the operating element is the finger f, the same holds true for the case where the operating element is the stylus s. The material forming the stylus s may be a material hard enough to be capable of pressing the flexible display 10. Examples of such a material include a metal material and a resin material such as plastic.

### (Configuration of Electrodes of Sensor Device)

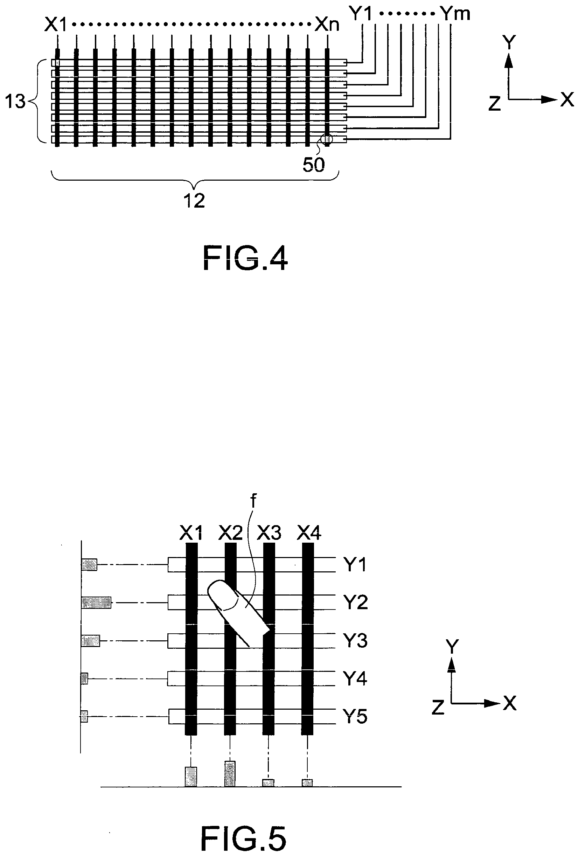

Fig. 4 is a plan view of the sensor device 11 seen from above in the Z-axis direction, showing only the electrode 12 and the Y electrode 13 in the sensor device 11. The X electrode 12 and the Y electrode 13 are each constituted of a plurality of wiring electrodes arrayed parallel to one another and form a so-called cross-matrix. The sensor device 11 includes n columns of the X electrodes 12 extending in the Y-axis direction thereof over the entire range, and m rows of the Y electrodes 13 extending in the X-axis direction thereof over the entire range. The X electrodes 12 are arrayed over the entire range of the input device 1 in the X-axis direction, and the Y-axis electrodes are arrayed over the entire range of the input device 1 in the Y-axis direction.

In the sensor device 11, the capacitive elements shown in Fig. 2 are formed at respective positions at which the X electrodes 12 and the Y electrodes 13 cross each other. So, the sensor device 11 includes n*m pieces of capacitive elements 50. In the sensor device 11, since larger values of n and m provide a higher density of the capacitive elements on the XY plane, an operation position can be detected more accurately.

### (Controller)

The controller c is typically constituted of a CPU (Central Processing Unit) or an MPU (Micro-Processing Unit). Here, the controller c includes the determination unit c1 and the signal generation unit c2 and executes various functions according to programs stored in a storage unit not shown in the figure. The determination unit c1 determines the state of the flexible display 10 based on an electrical signal (input signal) output from the sensor device 11. The signal generation unit c2 generates an operation signal based on the determination result.

Further, the controller c includes a drive circuit for driving the input device 1. The drive circuit outputs a drive signal to each of the capacitive elements 50 at predetermined time intervals. Furthermore, the determination unit c1 processes an output for the drive signal from each of the capacitive elements 50 and determines an input operation on the input device 1 by the user.

Fig. 5 is a diagram showing an example of output signals that are output from the sensor device 11 when the flexible display 10 receives an operation by the finger f of the user. A bar chart shown along the X axis of Fig. 5 indicates the amount of capacitance change from a reference capacitance in any capacitive element formed by each X electrode 12. Further, a bar chart shown along the Y axis of Fig. 5 indicates the amount of capacitance change from a reference capacitance in any capacitive element formed by each Y electrode 13.

The determination unit c1 of the controller c shown in Fig. 3 calculates coordinates in the X-axis direction and the Y-axis direction of the operation position by the finger f on the flexible display 10, based on the amounts of capacitance change obtained from the X electrodes 12 and the Y electrodes 13. Specifically, in Fig. 5, the determination unit c1 calculates an X coordinate of the operation position by the finger f based on a ratio of the amounts of capacitance change in the sensor device 11 formed by the X electrodes 12 (X1, X2, X3, X4), and calculates a Y coordinate of the operation position by the finger f based on a ratio of the amounts of capacitance change in the sensor device 11 formed by the Y electrodes 13 (Y1, Y2, Y3, Y4). With this, the determination unit c1 outputs the coordinates of the operation position in the flexible display 10 to the signal generation unit c2 (see Fig. 3).

The determination unit c1 can use, as an evaluation value on whether the flexible display 10 receives an operation or not, the maximum value of the amounts of capacitance change in the capacitive elements formed by the respective X electrodes 12 or Y electrodes 13.

Further, the determination unit c1 can use, as an evaluation value on whether the flexible display 10 receives an operation or not, a combined value of the amounts of capacitance change in the capacitive elements formed by the respective X electrodes 12 (the combined value is a combined value of values of the bar chart shown along the X axis of Fig. 5 and is hereinafter referred to as X combined value). Further, instead of the X combined value, a combined value of the amounts of capacitance change in the capacitive elements formed by the respective Y electrodes 13 (the combined value is a combined value of values of the bar chart shown along the Y axis of Fig. 5 and is hereinafter referred to as Y combined value) may be used. Furthermore, instead of the X combined value or the Y combined value, a value obtained by further adding the X combined value and the Y combined value may be used.

Specifically, a threshold value is set for the determination unit c1. In the case where the evaluation value is the threshold value or larger, the determination unit c1 determines that the flexible display 10 receives an operation. The determination unit c1 outputs a result of the determination to the signal generation unit c2 (see Fig. 3). The signal generation unit c2 generates an operation signal in accordance with the output signal from the determination unit c1.

The determination unit c1 can set any value as a threshold value. For example, the determination unit c1 can set a low threshold value for users such as women and children having weak finger power or a high threshold value for users having strong finger power.

In such a manner, in the presently discussed input device 1, it is possible to accurately determine a position at which the flexible display 10 receives an operation.

### (Structure of support layer)

As described above, the reference electrode 14 and the flexible display 10 are supported by the base plate 11b via the support layer 11a. The support layer 11a has a configuration in which the reference electrode 14 and the flexible display 10 are supported on the base plate 11b by only the plurality of first structures 15 shown in Figs. 1 and 2.

Here, with the configuration of the support layer 11a, sufficient displacements of the reference electrode 14 and the flexible display 10 downwardly in the Z-axis direction can be obtained, also in the case where the user performs an operation by a smaller pressing force.

Hereinafter, simulations that were performed in order to study the configuration of the support layer 11a will be described.

### (1) First Simulation

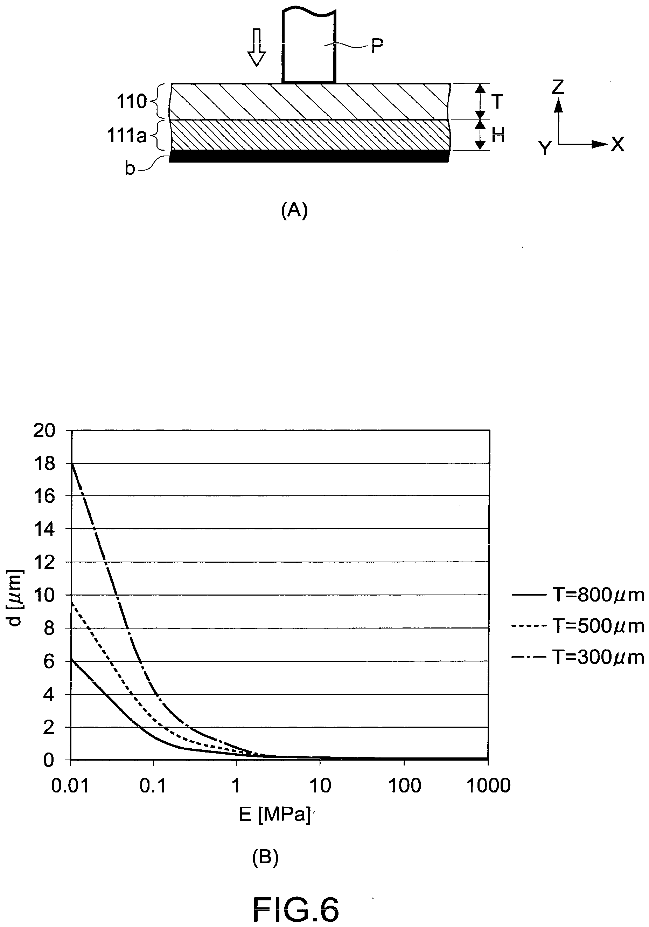

Fig. 6(A) is a schematic configuration diagram of a first simulation. This simulation was performed on the assumption that the support layer is filled with a single material, unlike the support layer 11a as discussed above.

In this simulation, as shown in Fig. 6(A), a model constituted of a sheet 110 having a Young's modulus E that is the same as a Young's modulus E of the flexible display 10 discussed above, a support layer 111a filled with a single material having a varying Young's modulus E, and a base material b formed of a sufficiently hard material is used. The thickness T of the sheet 110 was set to 300 [µm], 500 [µm], and 800 [µm], and a lower surface of the support layer 111a in the Z-axis direction was restricted by the base material b.

In the model shown in Fig. 6(A), assuming that the sheet 110 receives an operation by a small pressing force, a calculation was performed under a condition that the sheet 110 is pressed by a constant force (0.25 [N]) with use of a cylindrical pressing element P having a diameter of 3 [mm].

Fig. 6(B) shows results of the calculation for a displacement d of the lower surface of the sheet 110 in the Z-axis direction. In Fig. 6(B), the horizontal axis indicates a Young's modulus E of a material with which the support layer 111a is filled, and the vertical axis indicates a displacement d of the lower surface of the sheet 110 in the Z-axis direction.

The results of this simulation show a trend of a larger displacement d as the Young's modulus E of the material with which the support layer 111a is filled becomes lower, and of a larger displacement as the thickness T of the sheet 110 becomes thinner.

The thickness T of the sheet 110 is actually determined based on the design of an electronic apparatus. In particular, in the case where the flexible display 10 is adopted as the sheet 110 discussed above, it is difficult to reduce the thickness T technically in some cases. So, in order to sufficiently increase the displacement d of the lower surface of the sheet 110 in the Z-axis direction, there is a demand for use of a material having a sufficiently small Young's modulus E as a material with which the support layer 111a is filled.

Here, when the lower surface of the sheet 110 in the Z-axis direction at the operation by the user shown in Fig. 2(B) and Fig. 2(C) has a displacement of 1 [µm] or larger, a capacitance change in the sensor device 11 can be sufficiently detected. Further, the flexible display 10 has a thickness of 800 [µm].

So, under a condition that T=800 [µm], it is desirable that the lower surface of the sheet 110 in the Z-axis direction have a displacement d of 1 [µm] or larger. To that end, it is necessary that the Young's modulus E of a material with which the support layer 111a is filled be 0.1 [MPa] or smaller.

However, the Young's modulus E of a generally-used silicon resin is about several tens to several hundreds of [MPa]. The Young's modulus E of a sponge, having a low Young's modulus E, remains about 1 to 10 [MPa]. Further, with a special sponge that is formed so as to reduce a Young's modulus E more, it is difficult to reduce a Young's modulus E to be 0.1 [MPa] or smaller.

In such a manner, since a Young's modulus E that can be expected for a single material has a limitation, it was found that a sufficient displacement d associated with the operation of a user is not obtained in the configuration in which the support layer 11a is filled with a single material.

### (2) Second Simulation

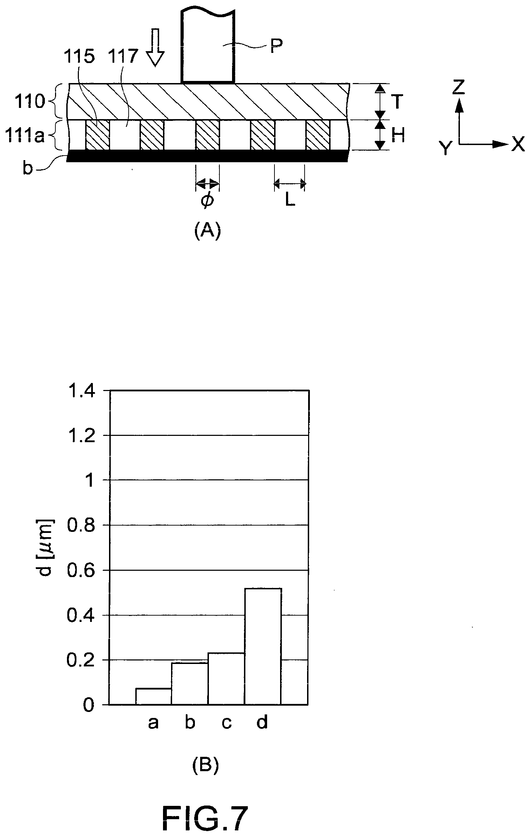

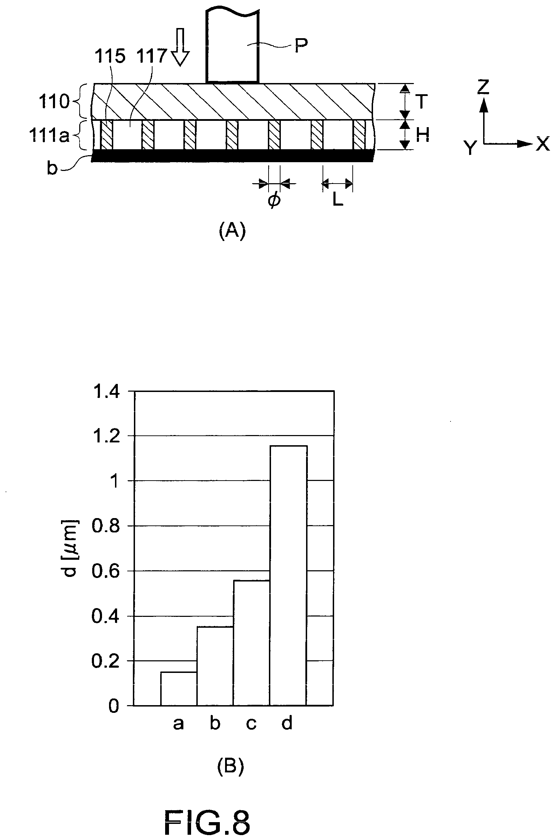

Figs. 7(A) and 8(A) are schematic configuration diagrams of a second simulation. In this simulation, unlike the configuration as in the first simulation, in which the support layer 111a is filled with a single material, a configuration in which cylindrical first structures 115 are arranged at intervals in the X-axis direction and the Y-axis direction in the support layer 111a was studied. In this configuration, in the support layer 111a, the first structures 115 and space portions 117 are alternately aligned in the X-axis direction and the Y-axis direction.

First, as shown in Fig. 7(A), with the diameter ϕ of the first structure 115 being set to 100 [µm], calculations were performed for the following four models in which a Young's modulus E of a material forming the first structure 115 and an interval L of the first structures 115 are changed.
Model a: E=2 [GPa], L=1 [mm]
Model b: E=2 [GPa], L=2 [mm]
Model c: E=100 [MPa], L=1 [mm]
Model d: E=100 [MPa], L=2 [mm]

In each model, as in the first simulation, a calculation was performed under a condition that the sheet 110 is pressed by a constant force (0.25 [N]) with use of a cylindrical pressing element P having a diameter of 3 [mm].

Fig. 7(B) shows results of the calculation for a displacement d of the lower surface of the sheet 110 in the Z-axis direction. In Fig. 7(B), the horizontal axis indicates a model name, and the vertical axis indicates a displacement d of the lower surface of the sheet 110 in the Z-axis direction.

The results of this simulation show a trend of a larger displacement d of the lower surface of the sheet 110 in the Z-axis direction as the Young's modulus E of the first structures 115 becomes lower and as the intervals between the first structures 115 become larger.

In this simulation, a large displacement d is obtained for the magnitude of the Young's modulus E of the material forming the first structures 115. This results from the fact that the sheet 110 is supported by the whole of the support layer 111a in the first simulation, while the sheet 110 is supported by only portions, having the first structures 115, of the support layer 111a in this simulation.

In other words, in this simulation, a support area of the sheet 110 in the support layer 111a is reduced and thus the hardness of the support layer 111a in the Z-axis direction (hereinafter, referred to as "apparent Young's modulus E'") is reduced. Thus, a large displacement d is obtained.

So, in order to reduce an apparent Young's modulus E' of the support layer 111a, a method of reducing the support area of the sheet 110 in the support layer 111a is effective. As such a method, there are conceived a method of reducing the diameter ϕ of the first structures 115 and a method of increasing the interval L between the first structures 115. However, when the interval L between the first structures 115 is too large, there is a possibility that the support layer 111a cannot support the sheet 110 appropriately. Thus, the method of reducing the diameter ϕ of the first structures 115 was studied.

As shown in Fig. 8(A), with the diameter ϕ of the first structures 115 being reduced from 100 [µm] to 50 [µm], calculations were performed for the following four models in which the Young's modulus E of the first structures 115 and the interval L of the first structures 115 are changed.
Model a: E=2 [GPa], L=1 [mm]
Model b: E=2 [GPa], L=2 [mm]
Model c: E=100 [MPa], L=1 [mm]
Model d: E=100 [MPa], L=2 [mm]

In each model, as in the first simulation, a calculation was performed assuming a case where the sheet 110 is pressed by a constant force (0.25 [N]) with use of a cylindrical pressing element P having a diameter of 3 [mm].

Fig. 8(B) shows results of the calculation for a displacement d of the lower surface of the sheet 110 in the Z-axis direction. In Fig. 8(B), the horizontal axis indicates a model name, and the vertical axis indicates a displacement d of the lower surface of the sheet 110 in the Z-axis direction. The value of the displacement d of the lower surface of the sheet 110 in the Z-axis direction in each model became larger than in the first simulation across the board. In particular, in the model d (E=100 [MPa], L=2 [mm]), the displacement d exceeded 1 [µm], and the apparent Young's modulus E' of the support layer 111a was 0.1 [MPa] or smaller.

The first and second simulations leaded to the configuration in which the reference electrode 14 and the flexible display 10 are supported by only the first structures 15 in the support layer 11a discussed above.

### (First Structure)

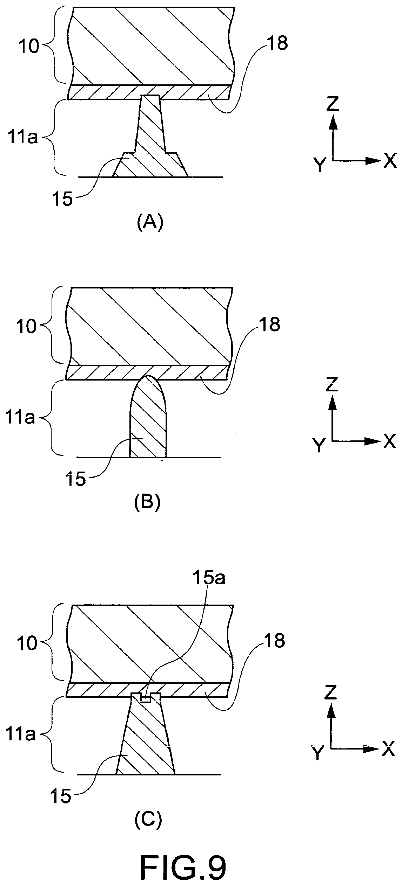

The first structure 15 can have any shape other than the shape shown in Fig. 2 and the cylindrical shape shown in the simulation described above. For example, the first structure 15 may have a shape having a step in the Z-axis direction shown in Fig. 9(A), a shape having a domal upper portion shown in Fig. 9(B), or a shape having a groove 15a on the upper end shown in Fig. 9(C). In this case, as compared with the structure having a cylindrical shape, the amount of compressive deformation in the Z-axis direction can be increased, and the domal shape having a larger curvature can provide a larger amount of deformation. Further, the shape of the first structure 15 may not have a circular cross section orthogonal to the Z axis as in the case of the cylinder (circular cone). The shape of the first structure 15 may have a polygonal cross section orthogonal to the Z axis or may have a cross section of a quadrangular prism (square pyramid) or a triangular prism (triangular pyramid), for example.

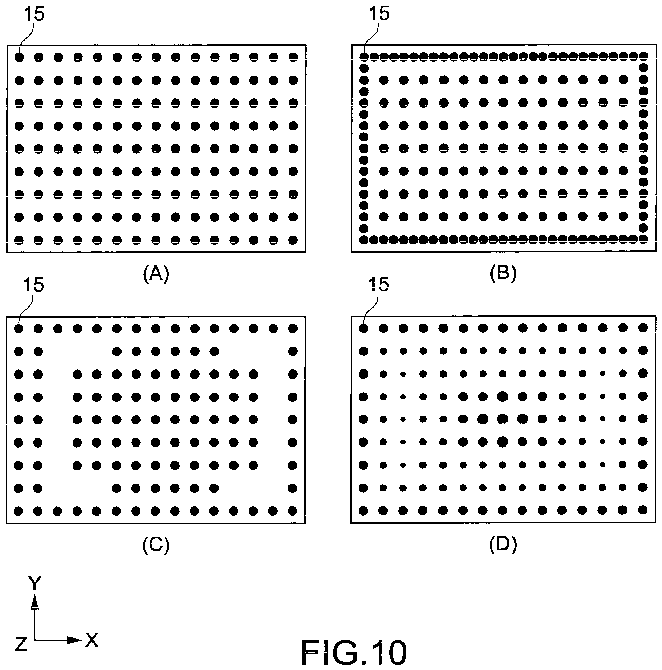

Further, the arrangement of the first structures 15 on the XY plane may not have a uniform configuration across the entire surface as shown in Fig. 10(A). For example, the arrangement of the first structures 15 may have a configuration as shown in 10(B) in which only an outer edge portion has a high density, or may have a configuration as shown in Fig. 10(C) in which nothing is arranged in a certain region. Further, the first structures 15 may be different from one another in size as shown in Fig. 10(D).

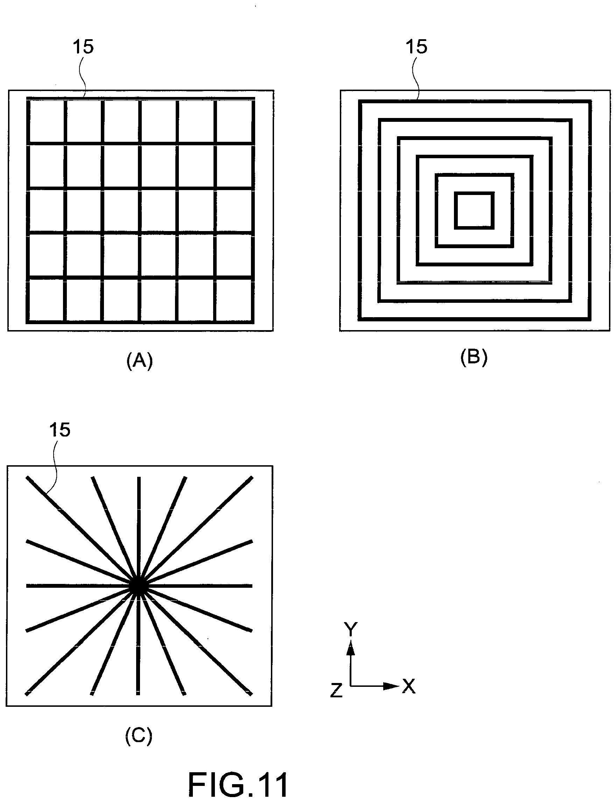

Furthermore, the first structures 15 may not be columnar and may be, for example, wall-like. Examples of wall-like first structures 15 include a grid-like first structure 15 shown in Fig. 11(A), a combination of rectangles having different diameters shown in Fig. 11(B), and a radial first structure 15 shown in Fig. 11(C).

### (Second Structure)

As described above, the second structures 16 increase a change in capacitance between the X electrode 12 and the Y electrode 13, which is associated with a displacement of the reference electrode 14 to the X electrode 12 side, by increasing the capacitance between the X electrode 12 and the reference electrode 14.

Hereinafter, simulations that were performed in order to study the configuration of the second structures 16 will be described.

### (3) Third Simulation

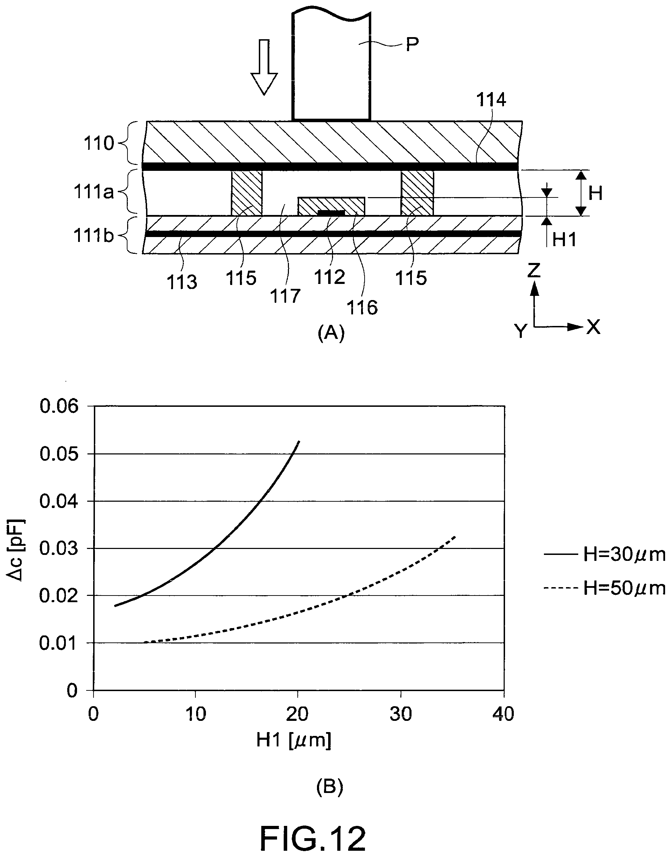

Fig. 12(A) is a schematic configuration diagram of a third simulation. In this simulation, the thickness of a second structure 116 in the Z-axis direction was studied. For the simulation, a model shown in Fig. 12(A), which is the same as the one used above, was used. The model is constituted of a sheet 110, a support layer 111a, and a base plate 111b. As in the input device 1 discussed above, the base plate 111b includes an X electrode 112 and a Y electrode 113, and a reference electrode 114 is formed on a lower surface of the sheet 110 in the Z-axis direction.

First structures 115 are arranged in the support layer 111a such that a space portion 117 having an interval H in the Z-axis direction is formed between the base plate 111b and the reference electrode 114. It was assumed that the second structure 116 is arranged at a position at which the X electrode 112 and the Y electrode 113 cross each other, and in the shape of the second structure 116, a cross section orthogonal to the Z axis is a square and the height in the Z-axis direction is H1.

In the model shown in Fig. 12(A), a calculation was performed under a condition that the sheet 110 is pressed with use of a cylindrical pressing element P having a diameter of 5 [mm] and the lower surface of the sheet 110 in the Z-axis direction is displaced downwardly in the Z-axis direction by 3 [µm]. The value of H was set to 30 [µm] and 50 [µm]. The magnitude of the initial capacitance between the X electrode 112 and the Y electrode 113 was set to 3 [pF].

Fig. 12(B) is a graph showing a change in change value ΔC of a capacitance before and after the press of the sheet 110 with use of the pressing element P, based on the magnitude of H1. With H=30 [µm] and H=50 [µm], it was found that as the value of the thickness H1 of the second structure 116 becomes larger, the change value ΔC of the capacitance becomes larger.

By this simulation, it was found that as the second structure 16 becomes thicker, a change in capacitance becomes larger and thus the sensitivity of the sensor device 11 becomes higher.

### (4) Fourth Simulation

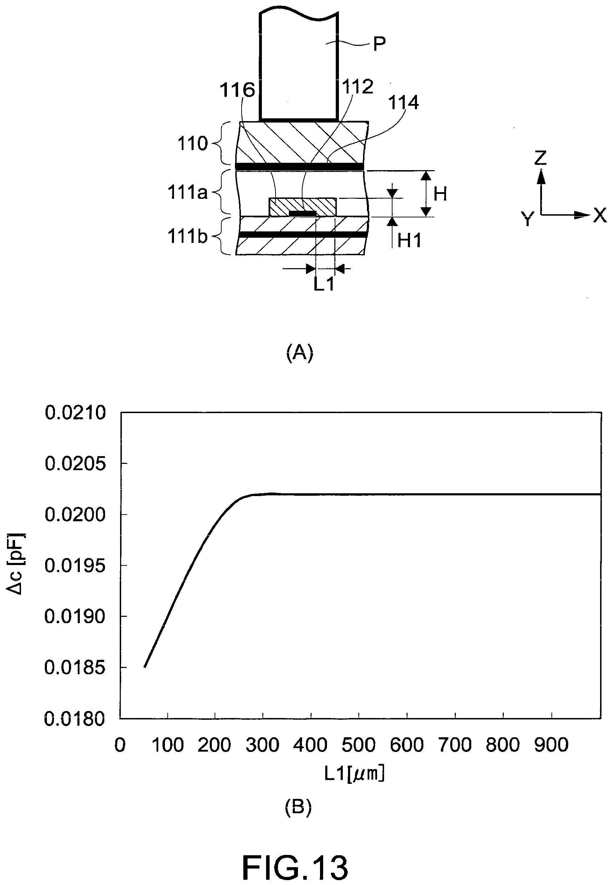

Fig. 13(A) is a schematic configuration diagram of a fourth simulation. In this simulation, a simulation model shown in Fig. 13(A) was used to study the widths in the X-axis direction and the Y-axis direction of the second structure 116. The thickness H of the support layer 111a was set to 50 [µm], and the thickness H1 of the second structure 116 was set to 30 [µm]. An outer width of the second structure 116 from the X electrode 112 was set to L1.

Fig. 13(B) is a graph showing a change in change value ΔC of a capacitance before and after the press of the sheet 110 with use of the pressing element P, based on the magnitude of H1. It was found that when an outer length L1 of the second structure 116 from the X electrode 112 is 300 or larger, a sufficient change value ΔC of a capacitance is obtained.

It should be noted that the second structure 16 only needs to be formed in the support layer 11a, and the shape thereof is not limited. Here, the second structure 16 has a shape whose cross section orthogonal to the Z axis is a square, but may have a shape whose cross section orthogonal to the Z axis is circular or of any polygon, for example. Further, a part or all of the outer shape of the second structure 16 may be formed of a curved surface.

### (Method of Forming First Structure and Second Structure)

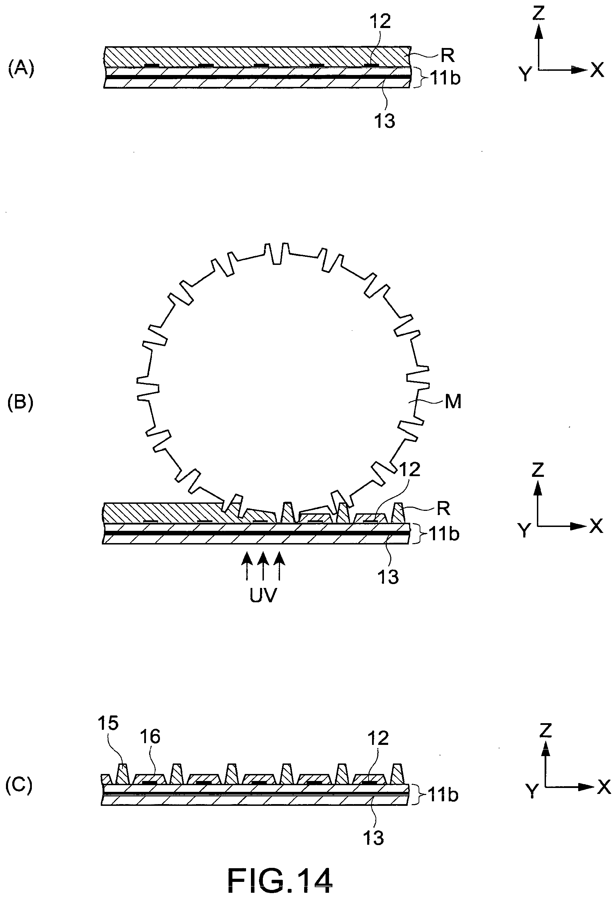

Fig. 14 is a diagram showing a method of forming the first structures 15 and the second structures 16 of the input device 1. First, as shown in Fig. 14(A), a UV resin R is arranged on the translucent base plate 11b. As the resin R, a solid sheet material or a liquid UV curable material may be used. As shown in Fig. 14(B), with use of a roll die M having a predetermined concavo-convex shape pattern, the concavo-convex shape pattern of the die M is transferred onto the UV resin R, and a UV application is performed from the base material 11b side to harden the UV resin R. In such a manner, as shown in Fig. 14(C), the first structures 15 and the second structures 16 are formed on the base plate 11b. It should be noted that the first structures 15 and the second structures 16 may be formed by, in addition to the forming using the UV resin described above, for example, general thermoforming (for example, press forming or injection molding) or discharge of a resin material with use of a dispenser or the like.

### (Modified Example of Configuration of Support Layer)

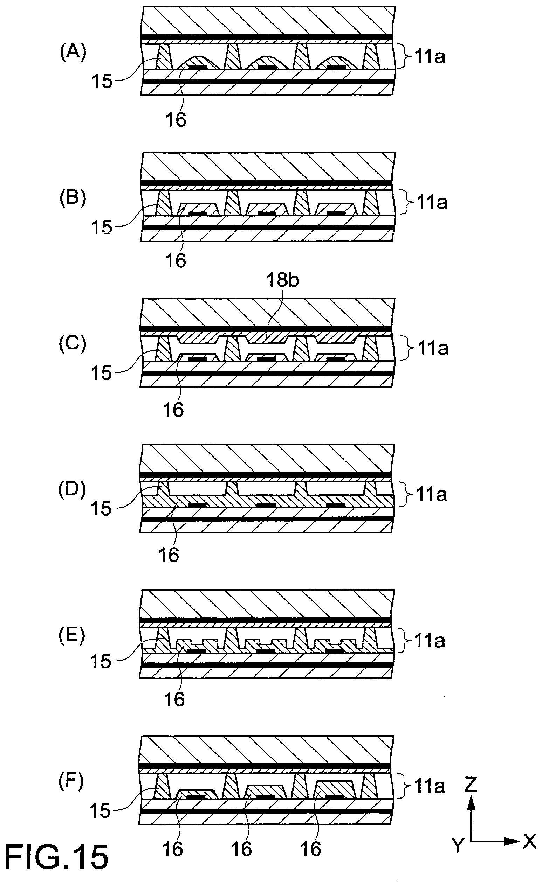

Fig. 15 shows modified examples of the support layer 11a as discussed above. The support layer 11a may have the second structures 16 each having domal, curved upper surface in the Z-axis direction as shown in Fig. 15(A), or the second structures 16 may be formed of a material different from the first structures 15 as shown in Fig. 15(B).

Further, in the support layer 11a, as shown in Fig. 15(C), the bonding layer 18 may be caused to protrude downwardly to provide second structures 18b on the upper side in the Z-axis direction, separately from the second structures 16 on the lower side in the Z-axis direction. In this case, the second structures 18b increase a capacitance between the X electrode 12 and the reference electrode 14 as in the case of the second structures 16. The support layer 11a only needs to be provided with any one of the structures 16 and the structures 18b. It should be noted that both of the structures 16 and the structures 18b may be omitted as necessary.

Further, in the support layer 11a, the first structure 15 and the second structure 16 may be continuously formed as shown in Fig. 15(D), a step may be formed on the upper surface of the second structure 16 in the Z-axis direction as shown in Fig. 15(E), and the height of each second structure 16 may differ as shown in Fig. 15(F).

### <Second Example>

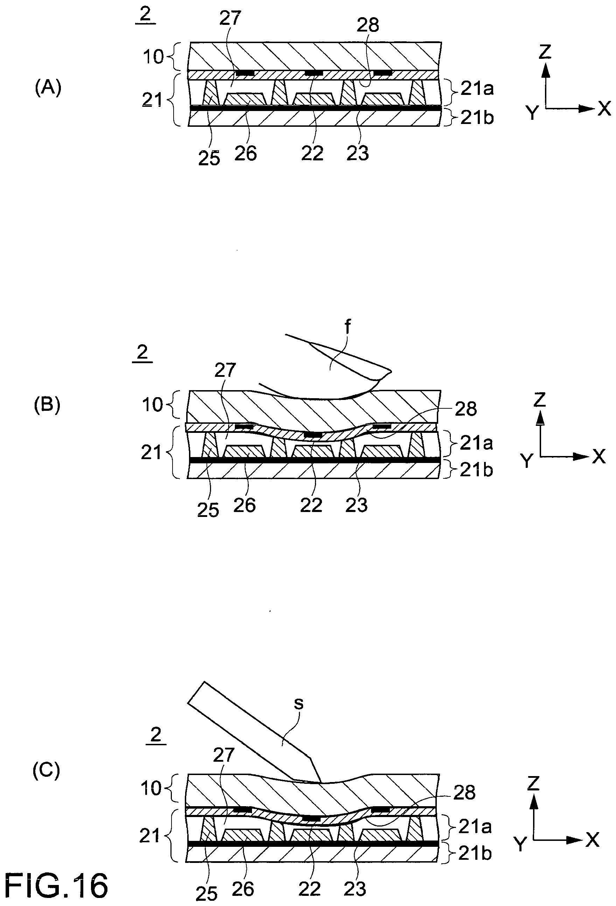

Fig. 16 is a fragmentary cross-sectional view of an input device 2. The configuration other than a sensor device 21 of the input device 2 is the same as that of the first example, and description thereof will be omitted as appropriate. Fig. 16 corresponds to Fig. 2 according to the first example.

### (Overall Configuration)

The input device 2 includes a sensor device 21, which is different from that of the first embodiment, and a flexible display 10, which is the same as discussed above. The sensor device 21 includes an X electrode 22 and a Y electrode 23 that are opposed to each other. The X electrode 22 and the Y electrode 23 constitute a capacitive element of a self-capacitance system. Further, due to the proximity of the X electrode 22 to the Y electrode 23, in the sensor device 21, a capacitance between the X electrode 22 and the Y electrode 23 increases.

### (Sensor Device)

The Y electrode 23 is formed on an upper surface of a base plate 21b in the Z-axis direction. On the other hand, the X electrode 22 is formed on a lower surface of the flexible display 10 in the Z-axis direction. In the sensor device 21, the proximity of the X electrode 22 to the Y electrode 23 can be detected based on a decrease in capacitance between the X electrode 22 and the Y electrode 23.

The sensor device 21 includes a plurality of first structures 25 arranged between the base plate 21b and the flexible display 10. The first structures 25 have the same configuration as the first structures 15 according to the first example. The upper surface of the first structure 25 in the Z-axis direction and the lower surface of the flexible display 10 in the Z-axis direction are bonded by a bonding layer 28. With this, a support layer 21a containing the first structures 25 and a space portion 27 is formed between the base plate 21b and the flexible display 10.

### Second structures 26 are formed between the first structures 25 on the upper surface of the base plate 21b in the Z-axis direction. The second structures 26 have the same configuration as the second structures 16 according to the first example.

Fig. 16(B) shows a state where the flexible display 10 receives an operation by the finger f of a user. In this state, the finger f exerts a force on the flexible display 10 downwardly in the Z-axis direction. At that time, the flexible display 10 is deflected downwardly in the Z-axis direction. The X electrode 22 bonded to the flexible display 10 is deflected downwardly in the Z-axis direction together with the flexible display 10 and comes close to the base plate 21b. With this, a capacitance of the sensor device 21 increases.

As described above, the second structures 26 are formed between the flexible display 10 and the base plate 21b. Since the material forming the second structures 26 has a specific dielectric constant higher than that of air present in the space portion 27, a capacitance between the X electrode 22 and the Y electrode 23 is large as compared with the structure without the second structures 26. For that reason, in the sensor device 21, also in the case where a displacement of the X electrode 22 to the Y electrode 23 side is small, that displacement can be detected. In other words, the sensor device 21 has a high sensitivity for detecting a pressing force associated with an operation on the flexible display 10 by the user.

Fig. 16(C) shows a state where the flexible display 10 receives an operation by a stylus s. As in the case shown in Fig. 16(B) where the operating element is the finger f, the same holds true for the case where the operating element is the stylus s.

### <Third Example>

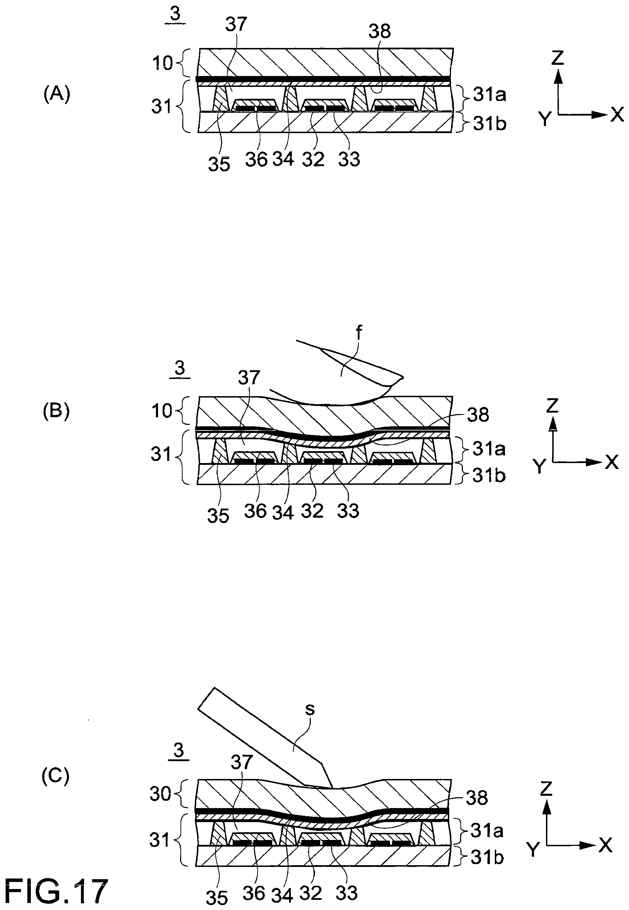

Fig. 17 is a fragmentary cross-sectional view of an input device 3. The configuration other than a sensor device 31 of the input device 3 is the same as that of the first example, and description thereof will be omitted as appropriate. Fig. 17 corresponds to Fig. 2 according to the first example.

### (Overall Configuration)

The input device 3 includes a sensor device 31, which is different from that of the first example, and a flexible display 10, which is the same as that of the first example. The sensor device 31 includes a base plate 31b including a first electrode 32 and a second electrode 33. The first electrode 32 and the second electrode 33 constitute a capacitive element of a mutual capacitance system. Further, the sensor device 31 includes a reference electrode 34, and due to the proximity of the reference electrode 34 to the base plate 31b, a capacitance between the first electrode 32 and the second electrode 33 decreases. Typically, the reference electrode 34 is connected to a ground potential.

### (Sensor Device)

The first electrode 32 and the second electrode 33 arranged side by side along the X axis are formed on an upper surface of the base plate 31b in the Z-axis direction. The reference electrode 34 is formed on a lower surface of the flexible display 10 in the Z-axis direction. In the sensor device 31, the proximity of the reference electrode 34 to the base plate 31b can be detected based on a decrease in capacitance between the first electrode 32 and the second electrode 33.

The sensor device 31 includes a plurality of first structures 35 arranged between the base plate 31b and the reference electrode 34. The first structures 35 have the same configuration as the first structures 15 according to the first example. The upper surface of the first structure 35 in the Z-axis direction and the lower surface of the reference electrode 34 in the Z-axis direction are bonded by a bonding layer 38. With this, a support layer 31a containing the first structures 35 and a space portion 37 is formed between the base plate 31b and the flexible display 10.

Second structures 36 are formed between the first structures 35 on the upper surface of the base plate 31b in the Z-axis direction. The second structures 36 have the same configuration as the second structures 16 according to the first example.

Fig. 17(B) shows a state where the flexible display 10 receives an operation by the finger f of a user. In this state, the finger f exerts a force on the flexible display 10 downwardly in the Z-axis direction. At that time, the flexible display 10 is deflected downwardly in the Z-axis direction. The reference electrode 34 bonded to the flexible display 10 is deflected downwardly in the Z-axis direction together with the flexible display 10 and comes close to the base plate 31b. With this, a capacitance of the sensor device 31 decreases.

As described above, the second structures 36 are formed between the reference electrode 34 and the base plate 31b. Since the material forming the second structures 36 has a specific dielectric constant higher than that of air present in the space portion 37, a capacitance between the first electrode 32 and the second electrode 33 is large as compared with the structure without the second structures 36. For that reason, in the sensor device 31, also in the case where a displacement of the first electrode 32 to the second electrode 33 side is small, that displacement can be detected. In other words, the sensor device 31 has a high sensitivity for detecting a pressing force associated with an operation on the flexible display 10 by the user.

Fig. 17(C) shows a state where the flexible display 10 receives an operation by a stylus s. As in the case shown in Fig. 17(B) where the operating element is the finger f, the same holds true for the case where the operating element is the stylus s.

### <Fourth Example>

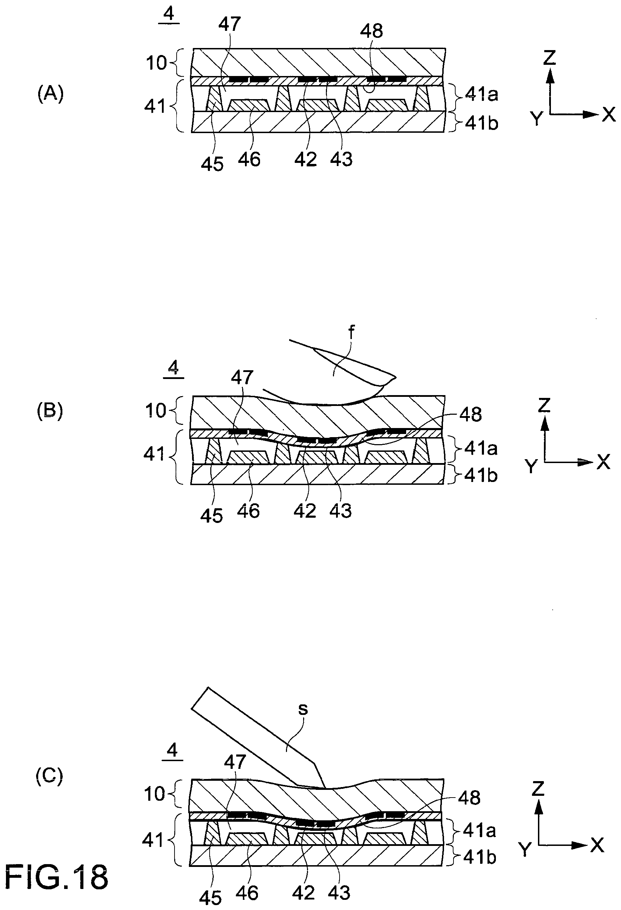

Fig. 18 is a fragmentary cross-sectional view of an input device 4. The configuration other than a sensor device 41 of the input device 4 is the same as that of the first example, and description thereof will be omitted as appropriate. Fig. 18 corresponds to Fig. 2 according to the first example.

### (Overall Configuration)

The input device 4 includes a sensor device 41, which is different from that of the first example, and a flexible display 10, which is the same as that of the first example. The sensor device 41 includes a base plate 41b and a bonding layer provided with a first electrode 42 and a second electrode 43. The first electrode 42 and the second electrode 43 constitute a capacitive element of a mutual capacitance system.

### (Sensor Device)

In the sensor device 41, the first electrode 42 and the second electrode 43 arranged side by side along the X axis are formed on a lower surface of the flexible display 10 in the Z-axis direction.

The sensor device 41 includes a plurality of first structures 45 arranged between the base plate 41b and the flexible display 10. The first structures 45 have the same configuration as the first structures 15 according to the first example. The upper surface of the first structure 45 in the Z-axis direction and the lower surface of the flexible display 10 in the Z-axis direction are bonded by a bonding layer 48. With this, a support layer 41a containing the first structures 45 and a space portion 47 is formed between the base plate 41b and the flexible display 10.

Second structures 46 are formed between the first structures 45 on the upper surface of the base plate 41b in the Z-axis direction. The second structures 46 have the same configuration as the second structures 16 according to the first example.

Fig. 18(B) shows a state where the flexible display 10 receives an operation by the finger f of a user. In this state, the finger f exerts a force on the flexible display 10 downwardly in the Z-axis direction. At that time, the flexible display 10 is deflected downwardly in the Z-axis direction. The first electrode 42 and the second electrode 43 that are bonded to the flexible display 10 are deflected downwardly in the Z-axis direction together with the flexible display 10 and come close to the second structures 46.

As described above, the second structures 46 are formed between the flexible display 10 and the base plate 41b. Since the material forming the second structures 46 has a specific dielectric constant higher than that of air present in the space portion 47, when the first electrode 42 and the second electrode 43 come close to the second structure 46, a capacitance between the first electrode 42 and the second electrode 43 increases.

If a configuration without the second structures 46 is adopted, due to the proximity of the first electrode 42 and the second electrode 43 to the base plate 41b, a capacitance between the first electrode 42 and the second electrode 43 increases. However, since the input device 4 includes the second structures 46 in addition to the base plate 41b, the amount of increase in capacitance between the first electrode 42 and the second electrode 43 significantly increases as compared with the configuration without the second structures 46.

For that reason, in the sensor device 41, also in the case where a displacement of the first electrode 42 to the second electrode 43 side is small, that displacement can be detected. In other words, the sensor device 41 has a high sensitivity for detecting a pressing force associated with an operation on the flexible display 10 by the user.

Fig. 18(C) shows a state where the flexible display 10 receives an operation by a stylus s. As in the case shown in Fig. 18(B) where the operating element is the finger f, the same holds true for the case where the operating element is the stylus s.

### <Fifth Example>

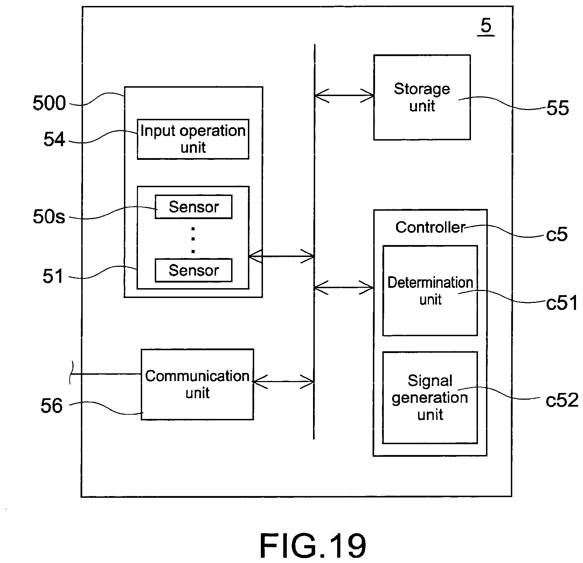

Fig. 19 is a block diagram showing a configuration of an input device 5.

### (Overall Configuration)

The input device 5 includes a sensor unit 500, a controller c5, a storage unit 55, and a communication unit 56.

### (Sensor Unit)

The sensor unit 500 includes a matrix sensor 51 and an input operation unit 54. The sensor matrix 51 includes a plurality of sensors 50s and outputs detection signals corresponding to a touch operation and a push operation performed on the input operation unit 54. The input operation unit 54 constitutes an input operation screen that is the same as a keyboard or the like that receives a push operation, and constitutes an input operation screen that is the same as a track pad or the like that receives a touch operation.

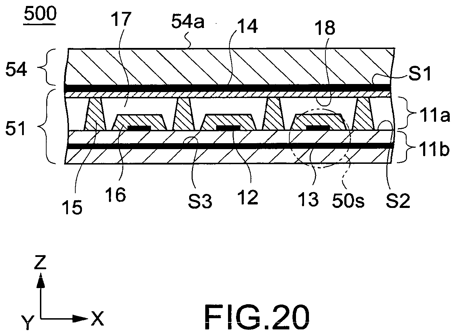

Fig. 20 is a fragmentary cross-sectional view of the sensor unit 500. The sensor unit 500 includes a surface S1 (first surface) that corresponds to a back surface of the input operation unit 54 and on which a reference electrode 14 is arranged, a front surface S2 (second surface) of a base plate 11b on which X electrodes 12 are arranged, and a surface S3 (third surface) of the base plate 11b in which Y electrodes 13 are arranged. The sensor matrix 51 has a laminate structure of a support layer 11a and the base plate 11b according to the first example, and individual capacitance components formed at respective cross regions of the plurality of X electrodes 12 and the plurality of Y electrodes 13 constitute the plurality of sensors 50s.

The plurality of sensors 50s are arrayed on the XY plane in a key array that is the same as a keyboard for a generally-used personal computer, for example. Each of the sensors 50s has a predetermined size and shape based on the arrangement thereof and a function assigned thereto. The number of capacitive elements constituting each of the sensors 50s may be one or more than one.

Each of the sensors 50s constitutes a sensor device of a mutual capacitance system. The capacitive element constituting each sensor 50s corresponds to the capacitive element 50 according to the first example and outputs a detection signal on a touch operation or a push operation by a user based on a capacitance between the X electrode 12 and the Y electrode 13 that changes in accordance with a user operation for the input operation unit 54.

The input operation unit 54 is constituted of the flexible display 10 according to the first example. In this case, in the input operation unit 54, characters or patterns of a key array that is the same as a keyboard for a generally-used personal computer are displayed. In addition thereto, the input operation unit 54 may be constituted of a cover made of metal or a synthetic resin, on which characters or patterns of a key array that is the same as a keyboard for a generally-used personal computer are drawn.

### (Controller)

The controller c5 corresponds to the controller c according to the first example and includes a determination unit c51 (detection unit) and a signal generation unit c52. The determination unit c51 determines, based on a change in capacitance of each sensor 50s, a first state in which a finger f (operating element) comes into contact with any one of the plurality of sensors 50s and a change from the first state to a second state in which the finger f presses the sensor 50s. The signal generation unit c52 generates an operation signal that is different between a touch state and a push state based on the determination of the determination unit c51.

The capacitances of the capacitive elements constituting the sensors 50s almost linearly change with respect to a change in distance between the reference electrode 14 and the base plate 11b, as in the first example. So, the difference in magnitude of a pressing force onto the input operation unit 54 can be easily detected. For example, whether the amount of capacitance change exceeds a predetermined threshold value or not allows a touch operation and a push operation to the input operation unit 54 to be distinguished from each other.

For example, in the state where the user puts the finger f or the like softly on an operation surface (Fig. 20) of the input operation unit 54, a weak force is applied to an operation surface 54a. On the other hand, in the case where the user performs an operation of pushing a key in, a larger load is applied to the operation surface 54a than a load of the state where the finger f or the like is softly put. In the sensor unit 500, the capacitances of the sensors 50s increase and decrease in accordance with the amount of the force. It is possible to estimate the load based on the magnitude of a value corresponding to this change in capacitance, and to distinguish between a touch state where the user puts the finger f softly and a push state where the user pushes the operation surface f in.

Here, the controller c5 is constituted so as to output key information for only the push state in key input, and thus an operational feeling of a generally-used keyboard can be achieved. In this case, the sensor unit 500 can detect a position of the finger f based on the amount of capacitance change in each sensor 50s in the touch state, and thus an input with touch coordinates being detected can be achieved.

On the other hand, the input device 5 can detect the coordinates in XY directions on the operation surface 54a and can also detect the magnitude of the load on the operation surface 54a accurately. With this effect, the following new input can be achieved.

### (Input Example 1)

In the case where the input operation unit 54 is constituted of a flexible display, a magnification percentage of an image displayed on the input operation unit 54 may be changed in accordance with a force to push the operation surface 54a in. For example, a map is displayed as an image, and the display of the image is controlled such that the display of a push-in position is changed at a magnification percentage that is proportional to a push-in amount.

### (Input Example 2)

In the case where the input device 5 is applied to an electronic apparatus such as a portable game device, the sensor unit may be used as an operation key of an accelerator pedal or a brake pedal of a vehicle. With this, an acceleration feeling or a deceleration feeling corresponding to the push-in amount can be provided to the user.

### (Input Example 3)

In the case where a plurality of photographs or documents are browsed on the input operation unit 54 constituted of a flexible display, the speed of page feeding may be changed in accordance with a push-in force to the operation surface 54a. For example, pages can be changed one by one when the operation surface 54a is push in weakly, and changed in unis of a plurality of pages when the operation surface 54a is push in strongly.

### (Input Example 4)

In the case where a drawing operation is performed on the input operation unit 54 constituted of a flexible display, the thickness or color of a line to be drawn may be changed in accordance with a push-in level. With this, an input close to an actual drawing feeling can be achieved.

The storage unit 55 is constituted of a RAM (Random Access Memory), a ROM (Read Only Memory), other semiconductor memories, and the like and stores calculated coordinates of an operation position of a finger or the like of a user and a program and the like used in various calculations by the determination unit c51. For example, the ROM is constituted of a non-volatile memory and stores appropriate threshold value data used in a determination of a touch operation and a push operation for the input operation unit 54, a program for causing the determination unit c51 to execute calculation processing such as a calculation of an operation position, and the like.

The threshold value data of the amount of capacitance change of each sensor 50s that is stored in the storage unit 55 can be changed as appropriate. The threshold value data may be common to the sensors 50s or may differ between the sensors 50s. In other words, in accordance with the location or key type of the sensor 50s, the sensitivity of a predetermined one or plurality of sensors 50s can be made different from the sensitivities of the other sensors 50s.

For example, the detection sensitivities of the individual sensors 50s constituting the sensor matrix 500 can be measured by detecting the outputs of the respective sensors 50s when a metallic plate of a predetermined weight is placed on the operation surface 54a of the input operation unit 54. At that time, for example, threshold value data for determining a touch operation only needs to be individually set for each of the sensors 50s and stored in the storage unit 55. With this, variations of characteristics between the sensors 50s can be reduced, or desired sensitivity characteristics can be set for a specific sensor 50s.

The communication unit 56 is constituted such that various types of operation signals generated by the signal generation unit c52 can be transmitted to the processing device p (see Fig. 3). A communication means in the communication unit c53 may be a wired one via a USB (Universal Serial Bus) or the like or a wireless one such as "Wi Fi" (registered trademark) or "Bluetooth" (registered trademark).

The signal generation unit c52 generates an operation signal in accordance with an output signal from the determination unit c51. Specifically, the signal generation unit c52 generates different operation signals for the touch state and the push state, and in the case where the push state is detected, generates a particular operation signal to each sensor 50 corresponding to each key of the keyboard.

### (Configuration of Electrodes)

In the sensor unit 500 shown in Fig. 20, by a press operation to the operation surface 54a, the reference electrode 14 supported by the support layer 11a is deflected to the base plate 11b side and a capacitance of the sensor 50s located immediately below the press position is reduced. With this, a touch operation or a push operation at the press position is detected.

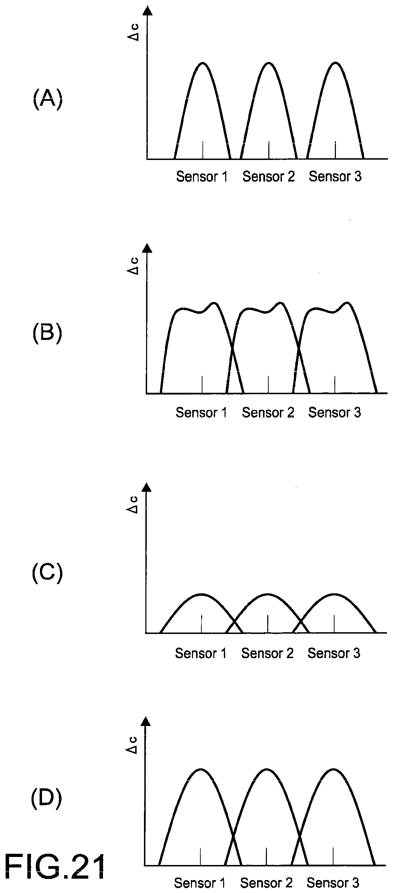

In a sensor matrix in which a plurality of sensors are two-dimensionally arrayed, a high accuracy is required for a plurality of adjacent sensor characteristics and individual sensor characteristics. For example, Fig. 21(A) shows an example in which sensitivity regions between adjacent sensors do not overlap. In this case, there is a possibility that the detection sensitivities between adjacent sensors are reduced. Fig. 21(B) shows an example in which a capacitance is not changed with good linearity. In this case, it is difficult to distinguish between a touch operation and a push operation. Further, Fig. 21(C) shows an example in which the amount of capacitance change of each sensor is small. In this case, it is difficult to determine an input position. So, in the sensor matrix, as shown in Fig. 21(D), the overlap of sensitivity regions between adjacent sensors, the change with good linearity in capacitance of each sensor, and the large amount of capacitance change are required.

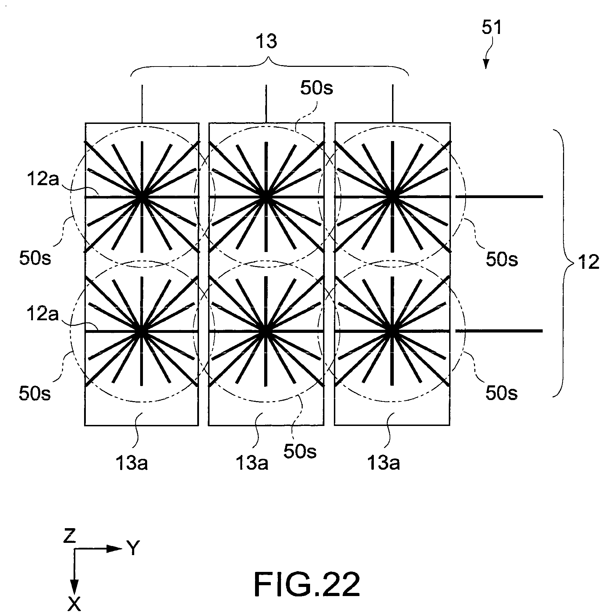

In order to stably ensure the sensor characteristics as shown in Fig. 21(D), for example, the X electrodes 12 and the Y electrodes 13 of the sensors 50s are constituted as shown in Fig. 22. Fig. 22 is a fragmentary plan view of the sensor matrix 51 and shows only the X electrodes 12 and the Y electrodes 13.

Here, the X electrodes 12 are arranged between the Y electrodes 13 and the reference electrode 14. The reference electrode 14 is typically connected to a ground potential. The X electrodes 12 close to the reference electrode 14 contain aggregates of linear electrodes 12a, and the Y electrodes 13 far from the reference electrode 14 contain planar electrodes 13a. The linear electrodes 12a correspond to the electrode example shown in Fig. 11(C). The sensors 50s are formed at cross regions of the linear electrodes 12a and the planar electrodes 13a.

The aggregate of the linear electrodes 12a is constituted of an aggregate of a plurality of rectilinear electrode patterns radially extending from the center portion. The linear electrodes 12a are formed in a line width of 200 µm or smaller, for example. The X electrodes 12 and the Y electrodes 13 are formed by a screen printing method, for example.

In the sensor matrix 51 including such a configuration of electrodes, the area in which the X electrode 12 and the Y electrode 13 are opposed to each other becomes small, and any of the X electrode 12 and the Y electrode 13 can be capacitively coupled to the reference electrode 14. With this, even when the amount of displacement of the reference electrode 14 is minute, the amount of capacitance change can be made high, and thus linearity performance of a capacitance change and a detection sensitivity are enhanced. Further, since the individual linear electrodes 12a have sensitivity regions, sensitivities at valleys between adjacent sensors 50s can be easily ensured.

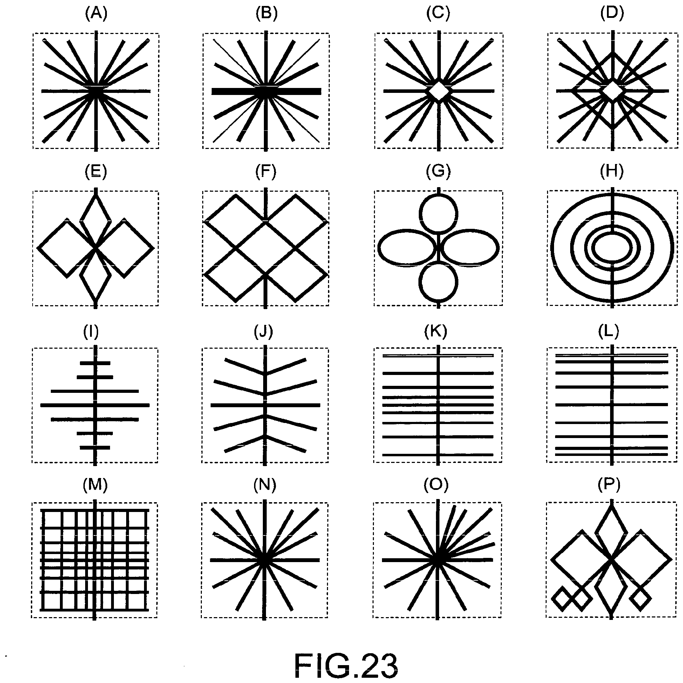

Fig. 23 is a schematic diagram showing a configuration example of the linear electrodes 12a. Fig. 23(A) corresponds to the linear electrodes of Fig. 22. In this example, the electrode density is different between the center portion of the capacitive element 51 and a circumferential portion thereof, and the amount of capacitance change due to the proximity of a finger in the center portion is larger. Fig. 23(B) shows an example in which one of the radial linear electrodes shown in the example of (A) is formed to be thicker than the other linear electrodes. With this, the amount of capacitance change on the thick linear electrode can be increased more than on the other linear electrodes. Further, Fig. 23(C) and (D) each show an example in which an annular linear electrode is arranged at substantially the center and linear electrodes are radially formed from the center. With this, the concentration of the linear electrodes at the center portion can be suppressed and the generation of a reduced-sensitivity region can be prevented.

Fig. 23(E) to (H) each show an example in which a plurality of linear electrodes each formed into an annular or rectangular annular shape are combined to form an aggregate. With this, the electrode density can be adjusted and the generation of a reduced-sensitivity region can be suppressed. Further, Fig. 23(I) to (L) each show an example in which a plurality of linear electrodes each arrayed in the Y-axis direction are combined to form an aggregate. The adjustment of the shape, length, pitch, or the like of the linear electrodes allows a desired electrode density to be obtained.

In addition, Fig. Fig. 23(M) to (P) each show an example in which linear electrodes are arranged asymmetrically in the X-axis direction or the Y-axis direction. The electrodes are formed such that the electrode density is asymmetric, and thus the detection sensitivities of the sensors 50s can be adjusted for each region. So, the detection sensitivities in the sensors 50s can be finely adjusted.

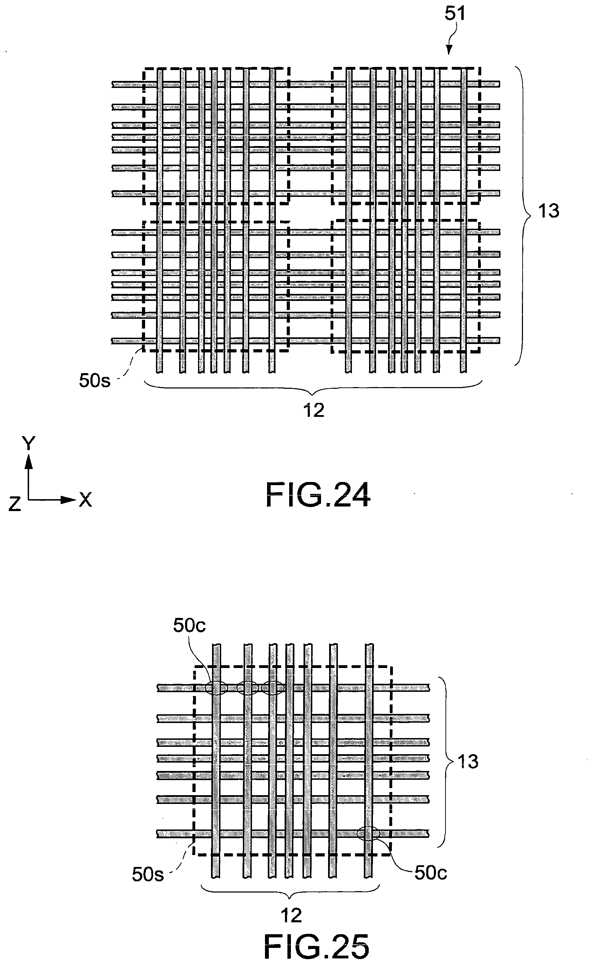

On the other hand, another configuration example of electrodes is shown in Fig. 24. Fig. 25 is an enlarged view of a part thereof. In this example, the X electrode 12 and the Y electrode are each constituted of a plurality of linear wiring electrodes and arrayed so as to be substantially orthogonal to each other. Each of the sensor 50s contains a plurality of crossing portions of the plurality of X electrodes 12 and Y electrodes 13. In other words, each of the sensors 50s is constituted of a plurality of capacitive elements 50c. With this, the detection sensitivities and output characteristics of high linearity performance of the individual sensors 50s are ensured. It should be noted that each of the sensors 50s only needs to contain at least one electrode crossing portion.

The plurality of electrode crossing portions, that is, the capacitive elements, which constitute each of the sensors 50s, are formed in a different density for each region. In the example of Fig. 24, the electrodes 12 and 13 are arrayed such that line distances between the electrodes 12 and between the electrodes 13 are sequentially increased as being separated from the center of the sensor 50s. For that reason, the density of the capacitive elements 50c is higher on the center side of the sensor 50s and lower on a circumferential side of the sensor 50s. As a result, output characteristics having a higher amount of capacitance change can be obtained at a position closer to the center of the sensor 50s.

It should be noted that without being limited to the example described above, for example, the sensor 50s may be configured such that the density is lower at a position closer to the center side. An interelectrode distance is optionally adjusted, and thus desired output characteristics can be obtained.

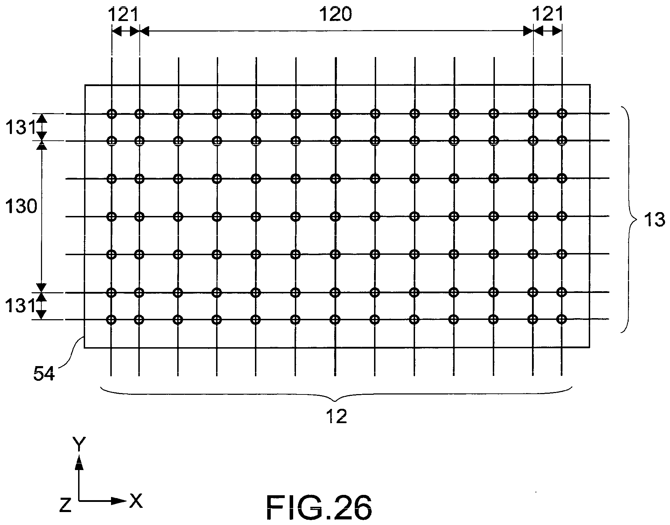

Fig. 26 shows still another configuration example of electrodes. Also in this example, the X electrode 12 and the Y electrode are each constituted of a plurality of linear wiring electrodes and arrayed so as to be substantially orthogonal to each other. In this example, the plurality of X electrodes and the plurality of Y electrodes 13 contain regions in which the X electrodes and the Y electrodes are arrayed in partially irregular pitches.

In the sensor unit 500 the circumferential portion of the input operation unit 54 is supported by a casing (not shown) of the input device 5 with use of a pressure-sensitive tape or the like. So, the circumferential portion of the input operation unit 54 is hard to be deformed in accordance with an input operation as compared with the center portion. As a result, an input position of the input operation unit 54 on the circumferential side may be detected by a sensor on an inner circumferential side than that input position.

To eliminate such concerns, in the sensor unit 500 of this example, the X electrodes 12 and the Y electrodes 13 are arrayed such that the interelectrode distances in regions 121 and 131 on the circumferential side of the sensor matrix 51 are shorter than the interelectrode distances in regions 120 and 130 on the center side thereof. With this, even when an input is performed in a circumferential region of the input operation unit 54, since a capacitive element that detects the circumferential region is located on the center side, an input position can be detected accurately.

It should be noted that without being limited to the case where portions with irregular wiring intervals are provided on the circumferential side of the sensor matrix as described above, an optional setting can be performed in accordance with specifications of a sensor or required characteristics.

### <Sixth Example>

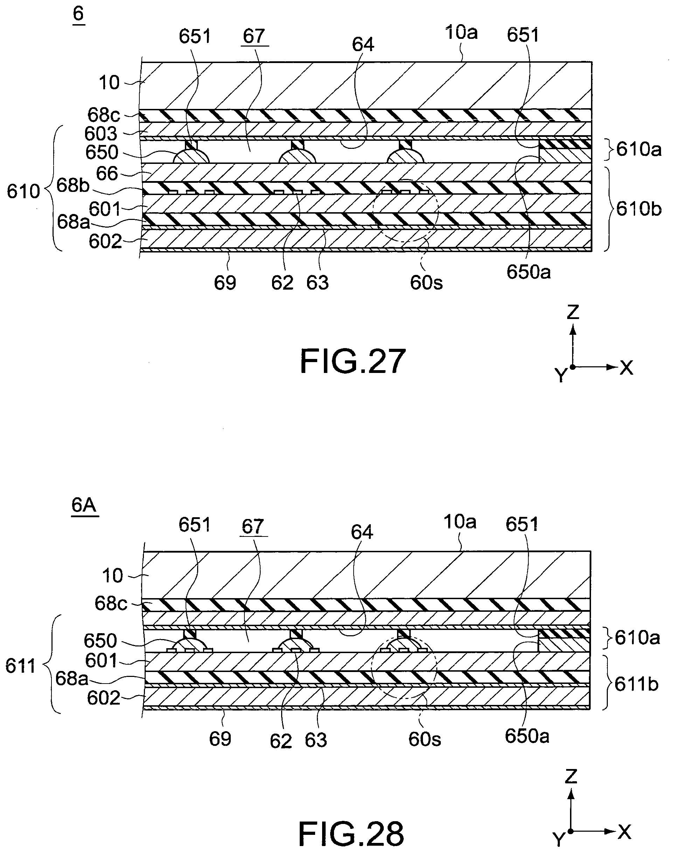

Fig. 27 is a fragmentary cross-sectional view of an input device 6. The configuration other than a sensor device 610 of the input device 6 according to this example is the same as that of the first example, and description thereof will be omitted as appropriate.

The sensor device 610 includes a base plate 610b including a plurality of capacitive elements 60s, a conductive layer 64, and a support layer 610a.

The base plate 610b includes an X electrode 62, a first base material 601 that supports the X electrode 62, a Y electrode 63, and a second base material 602 that supports the Y electrode 63. The X electrode 62 is constituted of a plurality of wiring electrodes arrayed in the X-axis direction and formed on a front surface (upper surface of the figure) of the first base material 601. Here, the X electrode 62 is constituted of wiring electrode groups each including an optional number of electrodes, in which individual cross regions with at least the Y electrode 63 are arrayed at predetermined pitches in the X-axis direction. Similarly, the Y electrode 63 is also constituted of a plurality of wiring electrodes arrayed in the Y-axis direction and formed on a front surface (upper surface of the figure) of the second base material 602. Here, the Y electrode 63 is constituted of wiring electrode groups each including an optional number of electrodes, in which individual cross regions with at least the X electrode 62 are arrayed at predetermined pitches in the Y-axis direction.

The first base material 601 is laminated on the second base material 602 via a bonding layer 68a. The X electrode 62 and the Y electrode 63 are each constituted of, for example, a metal material such as Ag (silver) or Cu(copper), a conductive paste containing those metal materials, or a conductive oxide such as ITO (indium tin oxide). The first and second base materials 601 and 602 are each constituted of, for example, a resin sheet of electrical insulation property, such as PET, PEN, PI, and PC.

A plurality of capacitive elements 60s are constituted as capacitive elements of a mutual capacitance system, which are formed at cross regions of the X electrodes 62 and the Y electrodes 63, and each have a predetermined capacitance corresponding to an area and a distance in which the electrodes 62 and 63 are opposed to each other and dielectric constants of the first base material 601 and the bonding layer 68a. Here, the plurality of capacitive elements 60s are arrayed in a matrix in a surface parallel to the XY plane.

The base plate 610b further includes an insulating layer 66 and a shielding layer 69.

The insulating layer 66 is constituted of an insulating resin film made of PET or PEN, for example. The insulating layer 66 is provided between the X electrodes 62 and the support layer 610a and coats the X electrodes 62 via a bonding layer 68b. With this, electrical contact between the conductive layer 64 and the first base material 601 (X electrode 62) can be prevented. The bonding layer 68b is formed in a thickness for coating the X electrodes 62 arranged on the front surface of the first base material 601 and connects the first base material 601 and the insulating layer 66 to each other. It should be noted that without being limited to the case of being constituted of a resin film, the insulating layer 66 may be an insulating film applied onto the first base material 601.

The shielding layer 69 is formed of a metallic layer made of copper foil or the like formed on a back surface (lower surface of the figure) of the second base material 602. The shielding layer 69 is for shielding electromagnetic noise that is input from the back surface side of the sensor device 6 to the capacitive elements 60s and is formed in a solid form, a mesh form, or a grid form, for example. The shielding layer 69 is connected to a ground potential, and thus the shielding effect described above can be enhanced. It should be noted that the installation of the shielding layer 69 may be omitted as necessary.

The conductive layer 64 is supported by a third base material 603. The third base material 603 is constituted of a resin sheet that is the same as the first and second base materials 601 and 602, and is bonded to the back surface of a flexible display 10 via a bonding layer 68c.

The conductive layer 64 corresponds to the reference electrode described in the first example and is bonded to the back surface of the flexible display 10 via the bonding layer 68c, the back surface of the flexible display 10 being opposed to the base plate 11b. The conductive layer 64 is formed in a solid form, a mesh form, or a grid form, for example, and is connected to a ground potential.

The conductive layer 64 is arranged to be opposed to the capacitive elements 60s (base plate 11b) via the support layer 610a. The conductive layer 64 has flexibility and is constituted to be partially deformable toward the capacitive elements 60s (base plate 11b) together with the flexible display 10 by receiving a pressing force, which is input to an operation surface 10a as a front surface of the flexible display 10.

The support layer 610a is arranged between the capacitive elements 60s (base plate 11b) and the conductive layer 64. The support layer 610a includes a plurality of structures 650, which support the conductive layer 64, and a space portion 67 formed between the plurality of structures 650.

The space portion 67 is constituted to be capable of partially changing a distance between the capacitive elements 60s (base plate 11b) and the conductive layer 64. With this, since a capacitance (cross capacitance) of a capacitive element 60s of the plurality of capacitive elements 60s, which comes close to a deformed area of the conductive layer 64, is changed, an input position or a pressing amount to the operation surface 10a can be electrostatically detected based on the change in the capacitance.

The space portion 67 is typically formed of an air layer, but may be filled with other gas (for example, inert gas) other than air. Further, the space portion 67 communicates around the plurality of structures 650, but depending on the shape of the structures 650 (for example, in the case where the structures 650 are formed in a grid form), the space portion 67 may be partitioned into a plurality of space portions.

Here, the plurality of structures 650 are formed of an elastic material capable of being elastically deformed in the Z-axis direction. As such a material, for example, in addition to a rubber material such as a silicon rubber or a urethane rubber, an appropriate shock-absorbing material such as a sponge is applicable. The plurality of structures 650 are each formed in a hemisphere or domal shape that is convex on the conductive layer 64 side. However, the plurality of structures 650 are not limited thereto and may be formed in other geometric shapes such as a cuboid shape and a cylindrical shape. Further, the plurality of structures 650 are not limited to the case of being formed to be punctiform, and may be formed linearly and parallel to the X-axis direction or the Y-axis direction, for example.

The support layer 610a further includes connection portions 651. The connection portions 651 are arranged between the plurality of structures 650 and the conductive layer 64 and connects the plurality of structures 650 to the conductive layer 64. With this, it is possible to bring the structures 650 into close contact with the conductive layer 64 and prevent a displacement or a separation between the plurality of structures 650 and the conductive layer 64. Further, since the connection portions 651 are formed at only positions immediately above the structures 650, it is possible to prevent the conductive layer 64 and the insulating layer 66 from sticking to each other in the process of connecting the support layer 610a and the conductive layer 64. As a connection material constituting the connection portions 651, a pressure-sensitive adhesive, an adhesive, and the like are used.

The plurality of structures 650 are formed on a front surface of the insulating layer 66 by using, for example, appropriate printing technology such as a screen printing method, a pad printing method, and a transfer method. At that time, a frame body 650a is formed of a material constituting the structures 650 at a circumferential portion of the front surface of the insulating layer 66. Further, at the time of forming the connection portions 651, a connection material constituting the connection portions 651 is also applied to the front surface of the frame body 650a. With this, the frame body 650a is integrally connected to the conductive layer 64.

The frame body 650a may be formed along a circumference of the insulating layer 66 continuously or intermittently. In the case where the frame body 650a is continuously formed along the circumference of the insulating layer 66, the space portion 67 can be put in isolation from the surrounding area of the sensor device 610, and thus the infiltration of water or the like into the space portion 67 can be blocked. On the other hand, in the case where the frame body 650a is intermittently formed along the circumference of the insulating layer 66, the space portion 67 can communicate with the surrounding area of the sensor device 610, and thus the generation of a pressure difference between the inner side and the outer side of the frame body 650a can be avoided.

Further, the plurality of structures 650 are arranged immediately above the capacitive elements 60s. In other words, each of the plurality of structures 650 is arrayed in at least one portion of the cross regions of the X electrodes 62 and the Y electrodes 63. With this, an isotropic pressure detection with a small sensitivity difference can be performed almost over the entire operation surface 10a.

In other words, in the sensor device 610, since the structures 650 are formed of an elastic material, even in the case where a press operation is input at a position immediately above any of the structures 650, due to an elastic deformation of the structure 650, a relative distance between a region of the conductive layer 64, which corresponds to the press position, and a capacitive element 60s opposite to the region is reduced. So, even in the case where the amount of deformation of the elastically-deformed structure 650 is small, a change in capacitance of the capacitive element 60s corresponding to that input position can be detected.

On the other hand, in the case where a press operation is input to a gap between the plurality of adjacent structures 650, since no structures 650 exist immediately below that input position, the region of the conductive layer 64, which corresponds to the press position, has a larger amount of deformation as compared with the case where a position immediately above the structure 650 is pressed. So, the deformed region of the conductive layer 64 is easily capacitively coupled to the surrounding capacitive elements 60s, and as a result, a change in capacitance of the capacitive elements 60s can be detected.

As described above, actions and effects that are the same as those in the first examplecan be obtained. Further, according to the sensor device 610, since the operation surface 10a with a small difference in input sensitivity can be achieved, it is possible to provide an excellent input operational feeling in the case where the flexible display 10 is applied as the input operation unit. Further, the XY coordinates of the input position can be detected highly accurately by a calculation of the center.

It should be noted that here the insulating layer 66 also has a function as the second structures in the sensor device 11 of the first example. In other words, the sensor device 610 corresponds to the structure integrating the first structures 15 and the second structures 16 in the sensor device 11 shown in Fig. 1.

### <Modified Example 1 of Sixth Example>

Fig. 28 is a fragmentary cross-sectional view showing a modified example of the sensor device according to the sixth example. It should be noted that in Fig. 28, portions corresponding to those of Fig. 27 are denoted by the same reference symbols and description thereof will be omitted.

In an input device 6A (sensor device 611) according to this modified example, the configuration of a base plate 611b is different from the configuration of the base plate 610b of the sensor device 610 shown in Fig. 27. In the base plate 611b, the plurality of structures 650 are directly provided on the first base material 601 that support the X electrodes 62. In other words, the sensor device 61A has a configuration in which the insulating layer 66 in the sensor device 6 of Fig. 27 is omitted.

Also in this modified example, actions and effects that are the same as those in the sixth exampledescribed above can be obtained. According to this modified example, a distance in which the conductive layer 64 and the capacitive element 60s are opposed to each other can be shortened, and thus the sensitivity of a press operation can be enhanced. Further, according to this modified example, since the configuration of the base plate 611b can be thinned, the thinning of the sensor device can be achieved.

### <Modified Example 2 of Sixth Example>

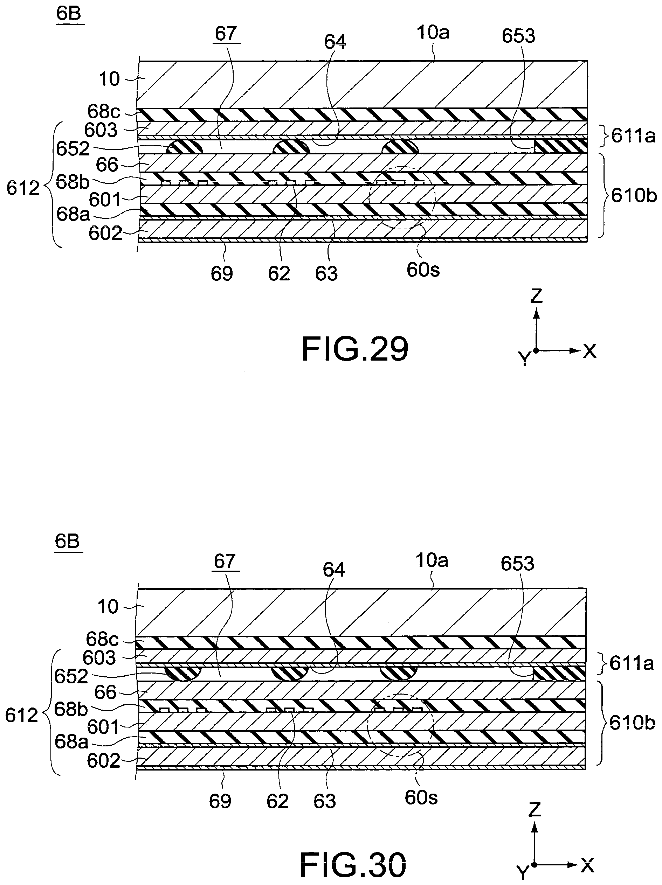

Fig. 29 is a fragmentary cross-sectional view showing another modified example of the sensor device according to the sixth example. It should be noted that in Fig. 29, portions corresponding to those of Fig. 27 are denoted by the same reference symbols and description thereof will be omitted.

In an input device 6B (sensor device 612) according to this modified example, the configuration of a support layer 611a is different from the configuration of the support layer 610a of the sensor device 610 shown in Fig. 27. In other words, in the support layer 611a according to this modified example, a plurality of structures 652 are formed of a connection material including a pressure-sensitive adhesive, an adhesive, and the like and have a function of forming a space portion 67 in the support layer 611a and a function of connecting an insulating layer 66 (base plate 610b) and a conductive layer 64 to each other. The plurality of structures 652 are each formed in a hemisphere or domal shape that is convex on the conductive layer 64 side.

It should be noted that in the sensor device 6B according to this modified example, a frame body 653 formed at the surrounding area of the insulating layer 66 is also formed of a single layer of the connection material that forms the structures 652.

Also in this modified example, actions and effects that are the same as those in the-sixth example described above can be obtained. According to this modified example, since the structures 652 can be formed of a single layer, the manufacture of the support layer 611a can be facilitated. With this, productivity can be enhanced and material costs can be reduced.

On the other hand, as shown in Fig. 30, the plurality of structures 652 may be each formed in a hemisphere or domal shape that is convex on the base plate 610b side. With this, when a press operation is performed at a position of a gap between the plurality of structures 652, a deformed region of the conductive layer 64 is prevented from sticking to curved peripheral surfaces of the structures 652. Thus, at the time of releasing the press operation, the deformed region of the conductive layer 64 can be appropriately and rapidly returned to the original position.

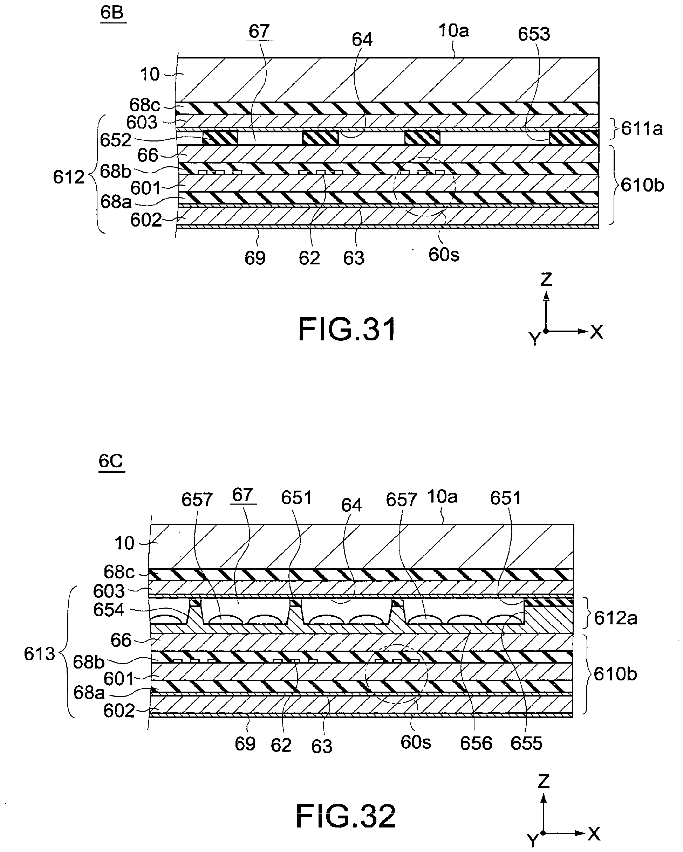

Alternatively, as shown in Fig. 31, the plurality of structures 652 may be formed in a cylindrical shape or a prism shape. In this case, the plurality of structures 652 can be formed of a pressure-sensitive sheet (double-sided sheet) punched out in a predetermined shape and size. Also with such a configuration, actions and effects that are the same as those in Fig. 30 can be obtained.

### <Modified Example 3 of Sixth Example>

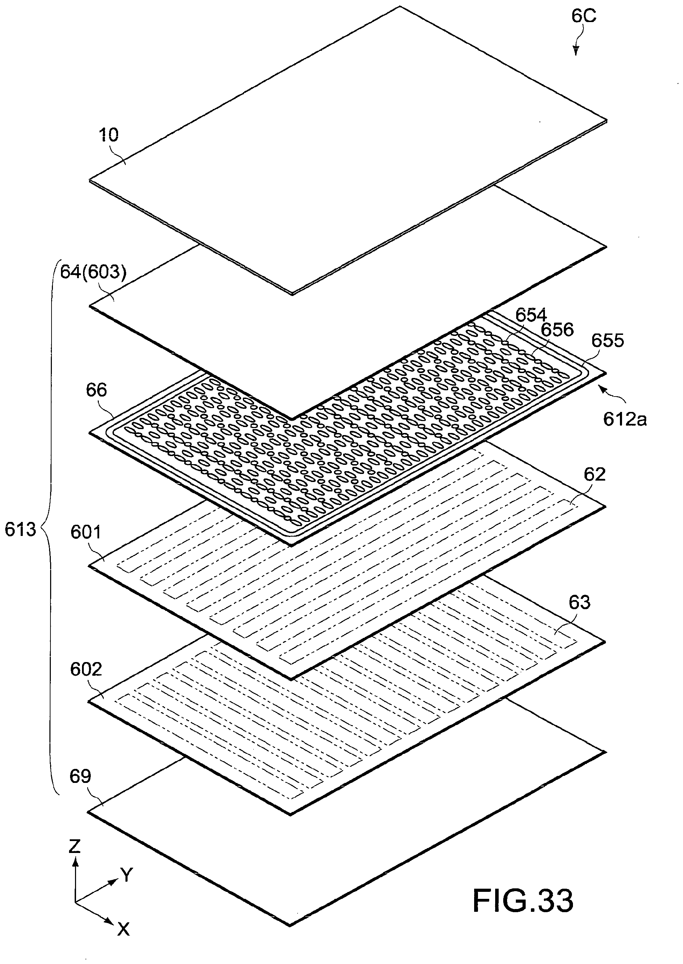

Fig. 32 is a fragmentary cross-sectional view showing another modified example of the sensor device according to the sixth example. Fig. 33 is a schematic exploded perspective view of an input device 6C. It should be noted that in Figs. 32 and 33, portions corresponding to those of Fig. 27 are denoted by the same reference symbols and description thereof will be omitted.

In an input device 6C (sensor device 613) according to this modified example, the configuration of a support layer 612a is different from the configuration of the support layer 610a of the sensor device 610 shown in Fig. 27. In other words, the support layer 612a according to this modified example includes a plurality of structures 654, a frame body 655, and a base portion 656, and those plurality of structures 654, frame body 655, and base portion 656 are integrally formed of a single resin material (for example, ultraviolet curable resin) and formed by a transfer method, for example.

Each of the plurality of structures 654 has a columnar shape that is the same as the first structure 15 in the first example. The frame body 655 is formed along the surrounding area of the insulating layer 66 continuously or intermittently. The base portion 656 is formed on a front surface of an insulating layer 66 and functions as an underlayer of the plurality of structures 654 and the frame body 655. Further, the plurality of structures 654 and the frame body 655 are connected to the conductive layer 64 via connection portions 651.

The support layer 612a in this modified example further include regulation portions 657 arranged between the plurality of structures 654. The regulation portions 657 are arranged on the base portion 656 that is opposed to a conductive layer 64 with a space portion 67 being sandwiched therebetween, and are configured to inhibit contact of the conductive layer 64 to the base portion 656. With this, also in the case where the base portion 656 (structures 654 and frame body 655) is formed of a material with tackiness (adherence property) of a predetermined value or more after curing, such as an ultraviolet curable resin, sticking of the conductive layer 64, which is deformed at the time of a press operation, to the base portion 656 can be inhibited and an appropriate input release operation can be ensured.

In this case, the regulation portion 657 is formed of a material having lower tackiness than the material that forms the base portion 656. The shape, the size, and the number of regulation portions 657 are not particularly limited. In this modified example, one or the plurality of regulation portions 657 are provided in each gap between the plurality of structures 654 that are adjacent in the X-axis direction. The shape of the regulation portion 657 is not particularly limited as long as the regulation portion 657 is shorter in height than the structures 654 and the frame body 655. For example, the regulation portion 657 is formed in a hemisphere or domal shape that is convex on the conductive layer 64 side, other curved shapes, or a cuboid shape.

### <Modified Example 4 of Sixth Example>

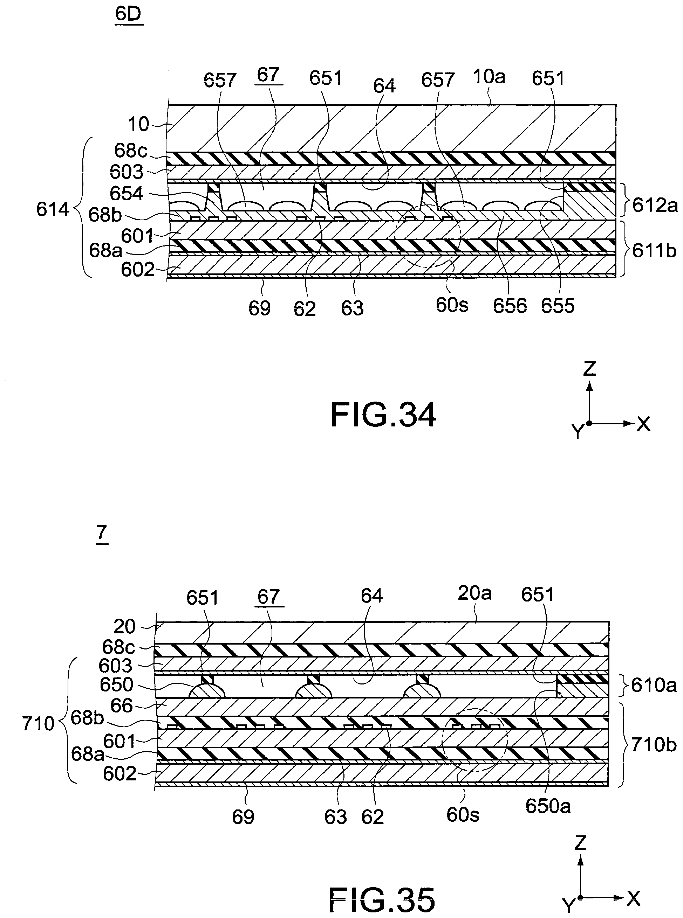

Fig. 34 is a fragmentary cross-sectional view showing another modified example of the sensor device according to the sixth example. It should be noted that in Fig. 34, portions corresponding to those of Figs. 27 and 32 are denoted by the same reference symbols and description thereof will be omitted.

An input device 6D (sensor device 614) according to this modified example includes a base plate 611b having the same configuration as the base plate shown in Fig. 28. In other words, the sensor device 614 has the configuration of the sensor device 610 of Fig. 27, in which the insulating layer 66 is omitted, a base layer 656 is formed on the first base material 601 that supports the X electrodes 62, and a plurality of structures 654 are arranged immediately above the capacitive elements 60s.

Also in this modified example, actions and effects that are the same as those in the sixth example described above can be obtained. According to this modified example, a distance in which the conductive layer 64 and the capacitive element 60s are opposed to each other can be shortened, and thus the sensitivity of a press operation can be enhanced. Further, according to this modified example, since the configuration of the base plate 611b can be thinned, the thinning of the sensor device can be achieved.

### <Seventh Example>

Fig. 35 is a fragmentary cross-sectional view of an input device. It should be noted that in Fig. 35, portions corresponding to those of the sixth example are denoted by the same reference symbols and description thereof will be omitted.

A sensor device 710 of this example is different from that of the sixth exampledescribed above in the configuration of a base plate 710b. In other words, in the base plate 710b a plurality of X electrodes 62 are arrayed so as to be located between a plurality of structures 650. In other words, the plurality of structures 650 are arrayed in regions other than cross regions of the plurality of X electrodes 62 and a plurality of Y electrodes 63. It should be noted that without being limited to the example of Fig. 35, the method of arraying the X electrodes 62 is also applicable to the configuration examples shown in Figs. 28 to 34 in the same manner.

Further, the input device 7 is different from that of the sixth exampledescribed above in the configuration including a flexible keyboard 20, instead of the flexible display 10. The flexible keyboard 20 is connected to the front surface of a third base material 603 via a bonding layer 68c, the third base material 603 supporting a conductive layer 64.

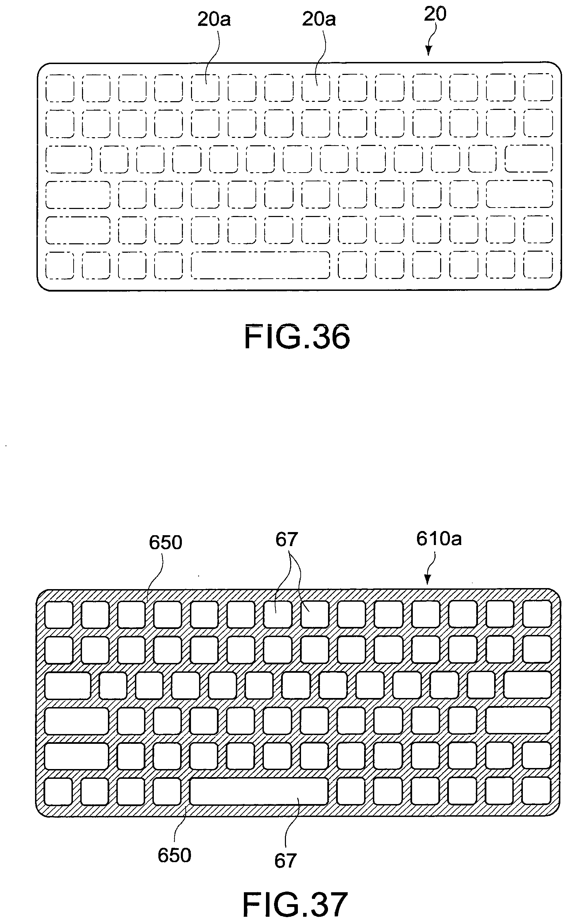

Fig. 36 is a plan view showing the whole of the flexible keyboard 20. The flexible keyboard 20 is formed of, for example, a plastic sheet of electrical insulation property, but may be formed of a metallic sheet. In this case, in the case where the flexible keyboard is formed of a metallic sheet, the conductive layer 64 can be omitted. A plurality of key regions 20a are arrayed on the front surface of the flexible keyboard 20. The flexible keyboard 20 is not limited to the example of being formed in a flat-sheet shape. For example, the key regions 20a may be formed of a predetermined concave-convex surface.

The plurality of key regions 20a are not limited to a case where all of the key regions 20a are formed in the same size and shape and may have a size different from other keys in accordance with the type of key. In each of the key regions 20a, an appropriate key display may be provided. The key display may display the type of key, the position (outline) of each key, or both of them.

Fig. 37 is a schematic plan view of the support layer 610a that constitutes the sensor device 710. The support layer 610a includes the plurality of structures 650 and space portions 67 formed between the plurality of structures 650. Here, the plurality of structures 650 are formed of a material having a relatively high rigidity, such as an epoxy-based resin, but may be formed of an elastic material having a relatively low rigidity, such as a urethane-based resin. Alternatively, the plurality of structures 650 may be a continuous body that includes a base portion and a frame body as shown in Fig. 32 and is formed of an ultraviolet curable resin. On the other hand, the space portions 67 are each formed in the shape and the size corresponding to the key region 20a of the flexible keyboard 20. On the other hand, the plurality of structures 650 are provided between the key regions 20a of the flexible keyboard 20 (regions shown with hatched lines in Fig. 37).

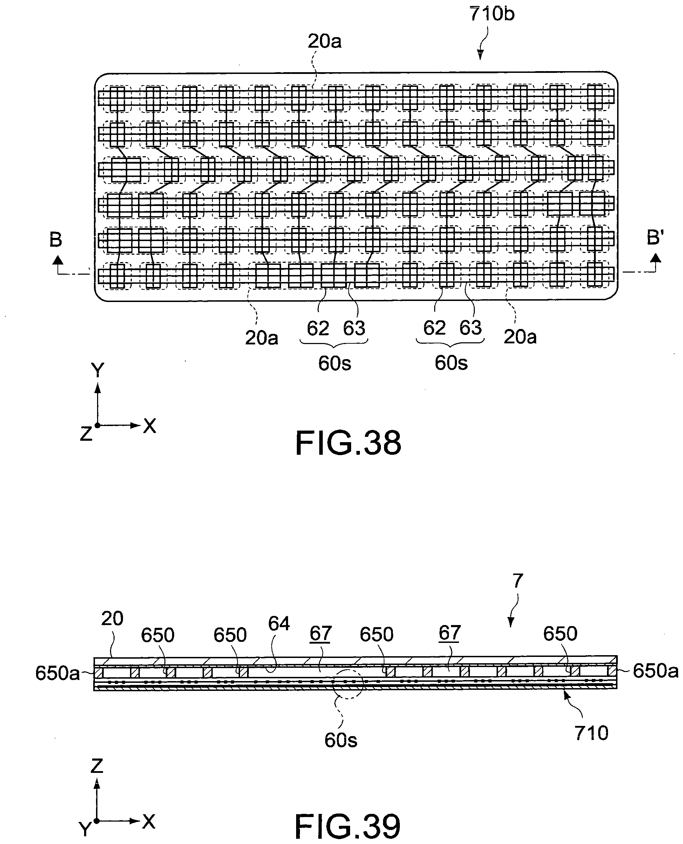

Fig. 38 is a schematic plan view of the base plate 710b that constitutes the sensor device 710. Fig. 39 is a cross-sectional view of the input device 7 taken along a direction of the line B-B' of Fig. 38. As described above, since the plurality of structures 650 are arrayed in respective regions other than the cross regions of the plurality of X electrodes 62 and the plurality of Y electrodes 63, the capacitive elements 60s are arranged at the positions opposed to the key regions 20a (space portions 67) in the Z-axis direction. In particular, the X electrodes 62 are wired by a single line between the key regions 20a and wired by branching into a plurality of lines in the key regions 20a. With this, since the number of capacitive elements 60s opposed to the respective key regions 20a is increased, the detection sensitivity of a key input operation can be enhanced.

In the input device 7 constituted as described above, since one or a plurality of capacitive elements 60s are arranged to be opposed to each of the key regions 20a of the flexible keyboard 20, an input position can be detected with high sensitivity.

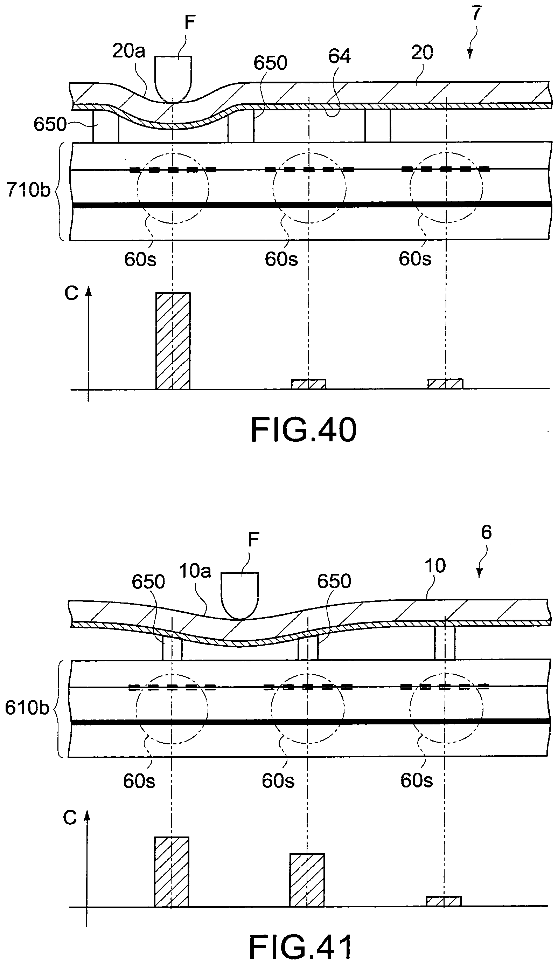

For example, Fig. 40 is a schematic view showing a relationship between an input operation to the input device 7 and an output of the capacitive element 60s. According to the input device 7 a significant capacitance change is generated between the capacitive element 60s located below the key region 20a and another capacitive element 60s adjacent to the capacitive element 60s, and thus it is possible to detect an input key position with high accuracy and suitably use the input device 7 as an input device such as a keyboard. In this case, the plurality of structures 650 are each formed of a material having a relatively high rigidity, and thus a capacitance change of another adjacent capacitive element 60s can be more reduced.

On the other hand, Fig. 41, shown as a comparison, is a schematic view showing a relationship between an input operation to the input device 6 according to the sixth example and an output of the capacitive element 60s. As shown in Fig. 41, in the case where the capacitive elements 60s are arranged to be opposed to the structures 650, the plurality of capacitive elements 60s near an input position generate capacitance changes. In this example, it is particularly suitable for the case where as in the first example, a press position (XY coordinates) of the flexible display 20 is specified by a calculation of the center.

Hereinabove, the present technology has been described, but the present technology is not limited to the examples described above, but only by the subject-matter of the claims.

For example, the sensor device can constitute a detection device such as a pressure sensor by a sensor device alone, without being provided with a flexible display. Instead of the flexible display, a sheet formed of a resin or the like can be bonded to the sensor device. Since the sensor device of the present technology has a high sensitivity, it is possible to comply with a wide variety of sheets.

Further, the present technology can be applied to information input apparatuses such as a touch pad, a mouse, and a keyboard, and information display apparatuses such as a television and a digital signage. Furthermore, the present technology is also applicable to information processing apparatuses such as a mobile phone, a smartphone, a laptop PC, and a tablet PC.

Moreover, above the sensor device including the plurality of capacitive elements arrayed in the XY plane has been described as an example, but the present technology is not limited thereto and can also be applied to a sensor device including a single capacitive element. In this case, the sensor device can be configured as a press switch for a game controller or the like.

Additionally, for example the reference electrode 14 has been described as being arranged between the flexible display 10 and the support layer 11a, but the reference electrode 14 may be incorporated in the flexible display 10. In this case, the reference electrode may be arranged on the flexible display 10 separately or may be configured by a conductive layer (for example, scanning electrode or the like of TFT (Thin-Film Transistor)) incorporated in the flexible display 10.

### Description of Symbols

- 1, 2, 3, 4, 5, 6, 7: input device
- 10: flexible display
- 20: flexible keyboard
- 11: sensor device
- 11a: support layer
- 11b: base plate
- 12: X electrode
- 13: Y electrode
- 14: reference electrode
- 15: first structure
- 16: second structure
- 17: space portion
- 18: bonding layer
- 50s, 60s: sensor

## Claims

1. A sensor device, comprising:
a flexible sheet (10, 30, 110) comprising a reference electrode (14, 34, 114) which is formed on a lower surface of the sheet (10, 30, 110) in the Z-axis direction;
a base plate (11b, 31b, 111b), wherein the base plate (11b, 31b, 111b) includes a first electrode (12, 32, 112) and a second electrode (13, 33, 113);
a support layer (11a, 31a, 111a) comprising first structures (15, 35, 115) with a first height (H) such that a space portion (17, 37, 117) having an interval with a first height (H) in the Z-axis direction is formed between the base plate (11b, 31b, 111b) and the reference electrode (14, 34, 114) and second structures (16, 36, 116) with a second height (H1) shorter than the first height (H) arranged in the space portion (17, 37, 117) in the Z-axis direction above both the first electrode (12, 32, 112) and the second electrode (13, 37, 113), and the space portion being formed between the second structures (16, 36, 116) and the reference electrode (14, 34, 114); wherein
the material forming the second structures (16, 36, 116) has a specific dielectric constant higher than that of air present in the space portion (17, 37, 117); and
the first electrode (12, 32, 112) and the second electrode (13, 33, 113) constitute a capacitive element, and a change in capacitance between the first electrode (12, 32, 112) and the second electrode (13, 33, 113) is detected when the reference electrode (14, 34, 114) is brought closer to the base plate (11b, 31b, 111b), wherein
the first electrode (12, 112) is an X electrode and the second electrode (13, 113) is a Y electrode; and
the first electrode (12, 112) and the second electrode (13, 113) cross each other at positions where the second structures (16, 116) are arranged, or wherein
the first electrode (32) and the second electrode (33) are both X electrodes arranged side by side on an upper surface of the base plate (31b).

2. The sensor device according to claim 1, wherein
the first structure (15, 35, 115) is formed of a plurality of columnar bodies, and
the plurality of columnar bodies are regularly arrayed.

3. An input device (1), comprising:
one or more sensors each including the sensor device of claim 1; and
a controller (c) including
a detection unit (c1) configured to detect the change in capacitance, and
a signal generation unit (c2) configured to generate an operation signal based on a result of the detection of the detection unit (c1).

## Patentansprüche

1. Sensorvorrichtung, aufweisend:
eine flexible Bahn (10, 30, 110), die eine Referenzelektrode (14, 34, 114) aufweist, welche auf einer unteren Oberfläche der Bahn (10, 30, 110) in der Z-Achsenrichtung ausgebildet ist;
eine Basisplatte (11b, 31b, 111b), wobei die Basisplatte (11b, 31b, 111b) eine erste Elektrode (12, 32, 112) und eine zweite Elektrode (13, 33, 113) enthält;
eine Stützschicht (11a, 31a, 111a), aufweisend erste Strukturen (15, 35, 115) mit einer ersten Höhe (H), sodass ein Raumabschnitt (17, 37, 117) mit einem Intervall mit einer ersten Höhe (H) in der Z-Achsenrichtung zwischen der Basisplatte (11b, 31b, 111b) und der Referenzelektrode (14, 34, 114) ausgebildet ist, und zweite Strukturen (16, 36, 116) mit einer zweiten Höhe (H1), die geringer als die erste Höhe (H) ist, welche im Raumabschnitt (17, 37, 117) in der Z-Achsenrichtung sowohl über der ersten Elektrode (12, 32, 112) als auch der zweiten Elektrode (13, 37, 113) angeordnet sind, und wobei der Raumabschnitt zwischen den zweiten Strukturen (16, 36, 116) und der Referenzelektrode (14, 34, 114) ausgebildet ist; wobei
das Material, das die zweiten Strukturen (16, 36, 116) ausbildet, eine spezifische Dielektrizitätskonstante aufweist, die höher als jene von Luft ist, welche im Raumabschnitt (17, 37, 117) vorhanden ist; und
die erste Elektrode (12, 32, 112) und die zweite Elektrode (13, 33, 113) ein kapazitives Element bilden und eine Änderung der Kapazitanz zwischen der ersten Elektrode (12, 32, 112) und der zweiten Elektrode (13, 33, 113) erkannt wird, wenn die Referenzelektrode (14, 34, 114) näher an die Basisplatte (11b, 31b, 111b) gebracht wird, wobei
die erste Elektrode (12, 112) eine X-Elektrode ist und die zweite Elektrode (13, 113) eine Y-Elektrode ist; und
die erste Elektrode (12, 112) und die zweite Elektrode (13, 113) einander an Positionen überkreuzen, an denen die zweiten Strukturen (16, 116) angeordnet sind, oder wobei
die erste Elektrode (32) und die zweite Elektrode (33) beide X-Elektroden sind, die Seite an Seite auf einer oberen Oberfläche der Basisplatte (31b) angeordnet sind.

2. Sensorvorrichtung nach Anspruch 1, wobei
die erste Struktur (15, 35, 115) aus mehreren säulenförmigen Körpern ausgebildet ist, und
die mehreren säulenförmigen Körper regelmäßig gruppiert sind.

3. Eingabevorrichtung (1), aufweisend:
einen oder mehr Sensoren, die jeder die Sensorvorrichtung nach Anspruch 1 enthalten; und
eine Steuerung (c), enthaltend
eine Erkennungseinheit (c1), die zum Erkennen der Änderung der Kapazitanz konfiguriert ist, und
eine Signalerzeugungseinheit (c2), die zum Erzeugen eines Betriebssignals basierend auf einem Ergebnis der Erkennung der Erkennungseinheit (c1) konfiguriert ist.

## Revendications

1. Dispositif de capteur comprenant :
une feuille souple (10, 30, 110) comprenant une électrode de référence (14, 34, 114) qui est formée sur une surface inférieure de la feuille (10, 30, 110) dans la direction d'axe Z ;
une plaque de base (11b, 31b, 111b), dans lequel la plaque de base (11b, 31b, 111b) comprend une première électrode (12, 32, 112) et une seconde électrode (13, 33, 113) ;
une couche de support (11a, 31a, 111a) comprenant des premières structures (15, 35, 115) ayant une première hauteur (H) de telle sorte qu'une partie d'espace (17, 37, 117) ayant un intervalle avec une première hauteur (H) dans la direction d'axe Z soit formée entre la plaque de base (11b, 31b, 111b) et l'électrode de référence (14, 34, 114) et des secondes structures (16, 36, 116) ayant une seconde hauteur (H1) plus courte que la première hauteur (H) disposées dans la partie d'espace (17, 37, 117) dans la direction d'axe Z à la fois au-dessus de la première électrode (12, 32, 112) et de la seconde électrode (13, 37, 113) et la partie d'espace étant formée entre les secondes structures (13, 36, 116) et l'électrode de référence (14, 34, 114) ; dans lequel
le matériau formant les secondes structures (16, 36, 116) présente une constante diélectrique spécifique plus élevée que celle de l'air présent dans la partie d'espace (17, 37, 117) ; et
la première électrode (12, 32, 112) et la seconde électrode (13, 33, 113) constituent un élément capacitif et un changement de capacité entre la première électrode (12, 32, 112) et la seconde électrode (13, 33, 113) est détecté lorsque l'électrode de référence (14, 34, 114) est amenée plus près de la plaque de base (11b, 31b, 111b),
dans lequel la première électrode (12, 112) est une électrode X et la seconde électrode (13, 113) est une électrode Y ; et
la première électrode (12, 112) et la seconde électrode (13, 113) se croisent à des positions où les secondes structures (16, 116) sont agencées ou dans lequel
la première électrode (32) et la seconde électrode (33) sont l'une et l'autre des électrodes X agencées côte à côte sur une surface supérieure de la plaque de base (31b).

2. Dispositif de capteur selon la revendication 1, dans lequel
la première structure (15, 35, 115) est formée d'une pluralité de corps en forme de colonne, et
la pluralité de corps en forme de colonne sont disposés de manière régulière.

3. Dispositif d'entrée (1) comprenant :
un ou plusieurs capteurs comprenant chacun le dispositif de capteur selon la revendication 1 ; et
un dispositif de commande (c) comprenant
une unité de détection (c1) configurée pour détecter le changement de capacité, et
une unité de génération de signal (c2) configurée pour générer un signal de fonctionnement en se basant sur un résultat de la détection de l'unité de détection (c1).
